# EUROPÄISCHE PATENTANMELDUNG

(11) **EP 2 360 721 A1**
(43) Veröffentlichungstag der Anmeldung: **24.08.2011**
(21) Anmeldenummer: 10154370.0
(22) Anmeldetag: 23.02.2010
(51) Int. Cl.: H01L 21/673

(54) **Vorrichtung zum Positionieren von mindestens zwei Gegenständen, Anordnungen, insbesondere Mehrschichtkörperanordnungen, Anlage zum Prozessieren, insbesondere zum Selenisieren, von Gegenständen, Verfahren zum Positionieren von mindestens zwei Gegenständen**

(71) Anmelder: Saint-Gobain Glass France, 92400 Courbevoie (FR)
(72) Erfinder: Jost, Stefan, 81543, München (DE); Palm, Jörg, 80797, München (DE); Fürfanger, Martin, 85643, Steinhöring (DE)
(74) Vertreter: Lendvai, Tomas

(57) **Zusammenfassung**

Die Erfindung betrifft eine Vorrichtung zum Positionieren (30a bis 30g) von mindestens zwei Gegenständen, insbesondere von mindestens zwei Mehrschichtkörpern (40, 50), mit jeweils mindestens einer zu prozessierenden Oberfläche (44, 54), zum Prozessieren, insbesondere zum Selenisieren, der mindestens zwei Gegenstände in einer Prozessieranlage (10). Ferner sind vorgesehen Anordnungen, insbesondere Mehrschichtkörperanordnungen (28a bis 28e), eine Anlage (10) zum Prozessieren, insbesondere zum Selenisieren, von Gegenständen und entsprechende Verfahren zum Positionieren von mindestens zwei Gegenständen. Mit dem Gegenstand der Erfindung soll die thermische Prozessierung von Gegenständen, insbesondere von Mehrschichtkörpern, effizienter gestaltet werden. Somit lassen sich die Investitionskosten, insbesondere für entsprechende Anlagen, und damit auch die Produktionskosten senken.

## Beschreibung

Die Erfindung betrifft eine Vorrichtung zum Positionieren von mindestens zwei Gegenständen zur Anordnung in einer Prozessieranlage, Anordnungen, insbesondere Mehrschichtkörperanordnungen, eine Anlage zum Prozessieren, insbesondere zum Selenisieren, von Gegenständen sowie entsprechende Verfahren zum Positionieren und Anordnen von mindestens zwei Gegenständen.

Nachfolgend wird das Prozessieren von Mehrschichtkörpern beschrieben, z. B. von Substraten (z. B. Glassubstrate). Auch wenn der spezielle Begriff des "Substrates" verwendet wird, so beziehen sich die Ausführungen auch immer allgemein auf "Mehrschichtkörper". Als Substrat kann ein "nacktes", unbeschichtetes Substrat bezeichnet werden, ebenso wie ein beschichtetes, also auch ein Mehrschichtkörper.

Ein Mehrschichtkörper wird beispielsweise durch Aufbringen einer funktionellen Schicht auf eine Trägerschicht ausgebildet. Damit die Schichten oder zumindest die funktionelle Schicht gewünschte physikalische und/oder chemische Eigenschaften aufweisen, muss der Mehrschichtkörper bzw. müssen die Schichten ggf. einer Prozessierung unterzogen werden. Das Prozessieren kann beispielsweise als ein Temperieren bzw. Tempern in Gegenwart eines Prozessgases vorgesehen sein. Hierfür sind Anlagen vorgesehen, in der ein Mehrschichtkörper aufheizbar ist.

Die Mehrschichtkörper werden eingesetzt, um beispielsweise (insbesondere großflächige) Dünnschichthalbleiter herzustellen, beispielsweise Dünnschichtsolarzellen bzw. -module. Solarstromanlagen werden z. B. mit Solarmodulen auf der Basis von Chalkopyrit-Halbleitern (z. B. CuInSe₂, abgekürzt "CIS" oder Cu(In,Ga)(S,Se)₂, abgekürzt "CIGSSE") betrieben. Solche Dünnschichtsolarmodule weisen zumindest ein Substrat (z. B. Glas, Keramik, Metall- oder Kunststofffolie), eine erste Elektrode (z. B. Molybdän Mo oder ein Metallnitrid), eine Absorberschicht (z. B. CuInSe₂ oder allgemeiner (Ag,Cu)(In,Ga,Al)(Se,S)₂), eine Frontelektrode (z. B. ZnO oder SnO₂) und Verkapselungs- und Abdeckmaterialien (z. B. EVA/Glas oder PVB/Glas, wobei EVA für Ethylen-Vinylacetat und PVB für Polyvinylbutyral steht) als wesentliche Bestandteile auf. Weitere Schichten, wie z. B. Alkalibarrierenschichten zwischen Glas und Mo oder Pufferschichten zwischen Absorber und Fensterschicht können eingesetzt werden, um den Wirkungsgrad und/oder die Langzeitstabilität zu verbessern. Wesentlicher weiterer Bestandteil eines typischen Dünnschichtsolarmoduls ist die integrierte Serienverschaltung, die aus Einzelsolarzellen eine serienverschaltete Kette bildet und damit höhere Betriebsspannungen ermöglicht. Im Folgenden werden jeweils die chemischen Zeichen für bestimmte Elemente angegeben, beispielsweise "Mo" für Molybdän oder "Se" für Selen.

Labortechnische Versuche zeigen, dass die derzeit bekannten Herstellverfahren noch weit mehr verbessert und dass durch verfahrenstechnische Ansätze und Optimierungen wesentliche Kosteneinsparungen erreicht werden können. Derzeit gibt es verschiedene Verfahren zur Herstellung der Dünnschicht-Solarmodule auf der Basis von Chalkopyrit-Halbleitern. Bei einem bekannten Zweistufen-Verfahren werden in einem ersten Schritt die sogenannten Precursorschichten Cu(Ga), In und Se auf das kalte, bereits mit einer Mo-Dünnschicht versehene Substrat abgeschieden. Dies kann z. B. durch Sputtern, Elektrodeposition, Siebdruck, Verdampfungsprozesse oder chemische Gasphasenabscheidung erfolgen. In einem zweiten Schritt wird das dergestalt beschichtete Substrat in einer Prozesskammer (eines entsprechenden Ofens) unter Ausschluss von Luft erhitzt, indem ein vorgegebenes erprobtes Temperatur-Profil von Raumtemperatur bis ca. 600°C durchfahren wird. Während dieses Temperprozesses bildet sich aus den Precursorschichten in einer komplexen Phasenumwandlung der gewünschte Chalkopyrit-Halbleiter.

Dieser Prozess kann als In-Line-Prozessierung bezeichnet werden, z. B. In-Line-Selenisierung. Auch die Sulfurierung ist auf diesem Wege möglich. In-Line-Temperprozesse erfordern die sichere Beherrschung schneller CIS-Schichtbildungsprozesse sowie der ebenfalls beschleunigten Aufheiz- und Abkühlprozesse für z. B. große beschichtete Glasplatten. Dabei wird ein Schichtpaket bestehend aus z. B. Kupfer, Indium und Gallium sowie einer abschließenden Bedeckung aus elementarem Selen mit relativ hohen Aufheizraten von bis zu einigen K/s auf höhere Temperaturen gebracht, bei der die zuvor aufgetragenen Einzelkomponenten zur Halbleiterverbindung reagieren (schnelle thermische Prozessierung, Rapid Thermal Processing, RTP, von Schichtstapel-Vorläuferschichten, SEL-Precursor, Stacked Elemental Layer). Die gegenüber Ofenprozessen wesentlich kürzeren Reaktionszeiten erlauben nun eine Übertragung auf Durchlaufprozesse. Die Prozesskammer weist z. B. einen Tunnel auf bzw. bildet einen Tunnel aus, der beispielsweise mit Schleusen abdichtbar ist oder ist als eine abgeschlossene Prozesskammern vorgesehen. Die Prozesskammer wird mit Energiequellen, also z. B. matrixförmig angeordneten Strahlern zum Aufheizen bestrahlt.
Die großflächige Prozessierung von Cu(In,Ga)(S,Se)₂ (CIGSSE) Chalkopyrit-Halbleitern auf Glassubstraten, ausgehend von SEL-Precursorn erfordert also folgende grundsätzliche Voraussetzungen:
- schnelle Aufheizraten im Bereich einiger K/s,
- homogene Temperaturverteilung über das Glassubstrat (lateral) und über die Substrat-Dicke,
- Gewährleistung eines ausreichend hohen, kontrollierbaren und reproduzierbaren Partialdrucks der Chalkogenelemente (Se und/oder S) während des RTPs (Vermeidung von Se- und/oder S-Verlusten bzw. sonstigen aufgebrachten Elementen),
- kontrollierte Prozessgas-Zufuhr (z. B. H₂, N₂, Ar, H₂S, H₂Se, S-Gas, Se-Gas),
- Maximal-Temperaturen oberhalb von 500°C.

Die großtechnischen In-Line-Verfahren sind prozess- und anlagentechnisch sehr komplex. Dies führt dazu, dass die Investitionskosten für diesen Prozessschritt einen nicht unwesentlichen Anteil an den gesamten Investitionskosten einer Solarfabrik einnehmen.

Aufgabe der Erfindung ist es daher, die thermische Prozessierung von Gegenständen, insbesondere von Mehrschichtkörpern, effizienter zu gestalten und so die Investitionskosten, insbesondere für entsprechende Prozessieranlagen, und damit auch die Produktionskosten zu senken.

Diese Aufgabe wird durch eine Vorrichtung zum Positionieren von mindestens zwei Gegenständen nach Anspruch 1, Anordnungen nach den Ansprüchen 14 und 15, eine Anlage zum Prozessieren nach Anspruch 16 und durch entsprechende Verfahren zum Positionieren nach den Ansprüchen 17 und 18 gelöst.

Insbesondere wird die Aufgabe vorrichtungsmäßig durch eine Vorrichtung zum Positionieren von mindestens zwei Gegenständen, insbesondere von mindestens zwei Mehrschichtkörpern mit jeweils mindestens einer zu prozessierenden Oberfläche gelöst, wobei die Vorrichtung zur Aufnahme der mindestens zwei Gegenstände, insbesondere Mehrschichtkörper, derart ausgebildet ist, dass sich die jeweils zu prozessierenden Oberflächen gegenüberliegen und die Gegenstände, insbesondere Mehrschichtkörper, so einen zwischen den Oberflächen angeordneten Prozessraum ausbilden, in dem im Wesentlichen die Prozessierung erfolgt. Damit sind die mindestens zwei Gegenstände als eine Mehrschichtkörperanordnung in einer Prozessieranlage prozessierbar, insbesondere selenisierbar.

Hierbei können die Mehrschichtkörper einen gewissen Abstand zueinander aufweisen, ggf. können die zu prozessierenden Oberflächen aber auch unmittelbar aufeinander liegen. Auch dann kann noch von einem Prozessraum gesprochen werden.

Ein wesentlicher Punkt der Erfindung liegt darin, zwei Mehrschichtkörper, z. B. Glassubstrate mit Precursor-Beschichtung, gleichzeitig prozessieren zu können (Dual-Substrate Head-to-Head RTP), da sie durch die Vorrichtung zum Positionieren (auch Stützvorrichtung) entsprechend gelagert oder gestützt sind. Beide Substrate sind mit den Precursor-Elementen, z. B. Cu, Ga, In, Se, Na, beschichtet, wobei diese beschichteten, zu prozessierenden Oberflächen gegenüberliegend angeordnet sind. Bei Beibehaltung der Prozesszeit führt dies zu verdoppeltem Anlagen-Durchsatz bei nahezu konstanter Anlagen-Grundfläche und vergleichbarem Anlagen-Investitionsvolumen. Das heißt, das Anlagen-Design kann im Wesentlichen beibehalten werden.

Die zu prozessierenden Mehrschichtkörper weisen, wie bereits oben beschrieben, bereits erste Beschichtungen auf (Precursor). Auf diese Beschichtungen werden weitere Elemente abgeschieden und/oder es finden Umwandlungen in den Beschichtungen statt, um den Precursor zum gewünschten Halbleiter überzuführen. Die sich gegenüberliegenden Oberflächen sind daher im Folgenden ganz allgemein als "Beschichtung", als "beschichtete Oberflächen", als "beschichtete Seite", als "zu prozessierende Oberflächen" etc. bezeichnet.

Die Erfindung ist nicht nur auf Chalkopyrit-Halbleiter bezogen, sondern auch auf sämtliche Anwendungen von funktionalen Dünnschichten auf Substraten (z. B. CdTe-Halbleiter und verwandte Halbleiter neben den Chalkopyrit-Halbleitern.

Vorzugsweise ist die Vorrichtung (und damit schließlich die Mehrschichtkörperanordnung) in einer Prozesskammer oder einem Prozesstunnel der Prozessieranlage mit einem Kammerraum (oder Tunnelraum) und/oder in einer Einrichtung zum Ausbilden eines reduzierten Kammerraums und/oder auf oder an einem Tragelement zum Transportieren der Mehrschichtkörperanordnung mittels einer Transportvorrichtung in die Prozessieranlage (d. h. in die Prozesskammer oder den
-tunnel) und aus dieser heraus oder an einer sonstigen geeigneten bzw. dafür vorgesehenen Stelle, anordenbar oder angeordnet ("anordenbar" kann auch als "vorsehbar" verstanden werden). Die Vorrichtung ist also z. B. derart ausgebildet, dass sie außerhalb der Prozessieranlage zur Aufnahme der Mehrschichtkörper angeordnet werden kann, um sie schließlich in die Kammer oder den Tunnel einzufahren. Hierfür ist beispielsweise die Transportvorrichtung vorgesehen, die die Mehrschichtkörperanordnung bewegt und in die Anlage und auch wieder aus dieser heraus transportiert. Die Vorrichtung ist hierfür vorzugsweise derart ausgebildet, dass sie mit der Transportvorrichtung auf dem Tragelement (einem Carrier, eine Art Transporteinrichtung, wie z. B. eine Transportplatte) transportierbar ist. Auch der Carrier allein kann die Transportvorrichtung ausbilden. Die Mehrschichtkörperanordnung kann auch manuell in die Anlage eingebracht oder direkt in dieser zusammengebaut werden.

Um möglichst wenig Prozessgas zu verbrauchen, ist es zweckmäßig, den Kammerraum zu reduzieren und einen expliziten Prozessraum zu schaffen. Zwischen den Substraten und den Energiequellen können daher mindestens teiltransparente Scheiben (z. B. aus Glaskeramik) oder für die gewählte Energiequelle hoch absorbierende Scheiben, die als sekundäre Energiequelle bzw. als Energietransmitter fungieren, angeordnet sein, die einen definierten Prozessraum bilden, um im Heizprozess das Abdampfen von flüchtigen Komponenten zu reduzieren bzw. zu minimieren. In bestimmten Phasen des Prozesses können in diesen Prozessraum zusätzliche Prozessgase (z. B. H₂, N₂, Ar, H₂S, H₂Se, S-Gas, Se-Gas und/oder andere) eingeführt werden. Dies kann mit einer Einrichtung zum Ausbilden eines reduzierten Kammerraums realisiert werden, z. B. einer Prozessbox oder einer Prozesshaube. Die Vorrichtung zum Positionieren ist derart ausgebildet, dass sie in der Prozessbox oder Prozesshaube anordenbar oder angeordnet ist.

Eine ausreichende Se-Menge ist nötig, um eine vollständige Selenisierung des metallischen (z. B.) CuInGa-Precursors zu gewährleisten. Se-Verlust würde zu einer unvollständigen Umwandlung des Precursors zum Chalkopyrit-Halbleiter und somit zu deutlichem Leistungsverlust des Solarmoduls führen. Die Gewährleistung einer ausreichenden Se-Menge erfolgt z. B. durch den Einsatz der Prozessbox. Entsprechendes gilt für andere derartige Prozesse.

Prozessboxen lassen sich offen oder auch geschlossen gestalten. Bei offenen Boxen sind keine oder nur teilweise Seitenwände vorhanden. Bei geschlossenen Boxen umschließen ein Bodenelement, ein Deckelelement und Seitenwände den Prozessraum im Wesentlichen vollständig. Prozesshauben sind in der Regel zum stationären Verbleib in der Prozessieranlage ausgebildet.

In einer bevorzugten Ausführungsform ist die Vorrichtung derart ausgebildet, dass die Mehrschichtkörper im Gebrauch sandwichförmig übereinanderliegend angeordnet sind und so einen unteren Mehrschichtkörper und einen oberen Mehrschichtkörper der Mehrschichtkörperanordnung ausbilden. Damit ist die Beschichtung bzw. die zu prozessierende Oberfläche obenliegend auf dem unteren Substrat und untenliegend auf dem oberen Substrat (Face-to-Face- oder Head-to-Head-Anordnung) angeordnet.

Vorzugsweise ist die Vorrichtung derart in dem Kammerraum der Prozesskammer anordenbar (oder an einer geeigneten bzw. dafür vorgesehenen Stelle), bzw. die Vorrichtung ist derart ausgebildet, dass die zwei Mehrschichtkörper derart an dieser anordenbar sind, dass diese und/oder die Vorrichtung zum Positionieren mindestens teilweise die Einrichtung zum Ausbilden eines reduzierten Kammerraums, vorzugsweise die Prozessbox, ausbilden. Je nach Ausgestaltung können also die Mehrschichtkörper bzw. die Substrate die Prozessbox ausbilden und ohne oder auch mit zusätzlichen Seitenwänden zusammenwirken. Auch kann die Vorrichtung zum Positionieren Teile (z. B. mindestens Teile der Seitenwände) der Prozessbox mit ausbilden. In diesem Falle würde der reduzierte Kammerraum, also der Prozessraum, dann im Wesentlichen dem Raum zwischen den Mehrschichtkörpern entsprechen. So kann z. B. auf eine explizite Prozessbox verzichtet werden.

Die Nutzung der Substrate und/oder der Vorrichtung zum Positionieren als Bestandteile der Prozessbox hat den Vorteil, die Prozessgase nur dort zuführen zu können, wo sie auch gebraucht werden. Somit ist eine Verringerung bzw. Vermeidung der eventuell auftretenden Rückseitenbeschichtung während der Prozessierung möglich. Durch die spezielle Anordnung der Substrate sind diese während der Prozessierung, also z. B. während der Selenisierung, nicht mehr innerhalb einer Prozessbox und somit außerhalb der Prozessgas-Umgebung angeordnet. Die Substrat-Rückseiten sind somit keiner Se- bzw. S-Atmosphäre mehr ausgesetzt. Das heißt, nur die zu prozessierenden Seiten bzw. Oberflächen sind dem Prozessgas ausgesetzt.

Ist eine Prozessbox zum Reduzieren des Kammerraums vorgesehen, so kann die erfindungsgemäße Vorrichtung zum Positionieren unmittelbar in dieser angeordnet werden. Letztendlich lässt sich die Prozessbox dann mit der Mehrschichtkörperanordnung in die Prozessieranlage befördern (z. B. mittels des ggf. beweglichen Carriers oder auch manuell). Es ist auch möglich, die Mehrschichtkörperanordnung außerhalb der Anlage "zusammenzubauen" und erst dann in die Kammer einzubringen (z. B. mittels des Carriers). Das heißt, die Vorrichtung ist auf dem Carrier angeordnet, so dass sich die zusammengebaute Mehrschichtkörperanordnung mittels der Transportvorrichtung in die Anlage einfahren lässt. Die Prozesskammer der Anlage könnte dann z. B. die oben beschriebene Prozesshaube aufweisen, so dass mit einem reduzierten Kammerraum gearbeitet werden kann.

Die (explizite) Einrichtung zur Ausbildung eines reduzierten Kammerraums und/oder die Vorrichtung zum Positionieren (die ggf. zum Teil die Einrichtung mit ausbildet) sind vorzugsweise derart ausgebildet, dass der aus Bodenelement und/oder unterem Substrat bzw. Deckelelement und/oder oberem Substrat gebildete (reduzierte) Raum ein geeignetes Volumen hat: er darf nicht zu groß sein, damit nicht zu viel Chalcogenmenge (Se oder S) oder ggf. auch flüchtige Reaktionsprodukte verdampfen (abzuschätzen aus dem Gleichgewichts-Dampfdruck bei Prozesstemperatur), aber auch nicht zu klein, damit bei temporären Verbiegungen des Substrats im Aufheizprozess die Substrate nicht die gegenüberliegende Gegenplatte berühren. Der Abstand zwischen Gegenplatte und Substrat sollte z. B. jeweils etwa zwischen 1 und 20 mm betragen. Grundsätzlich wäre jedoch auch unmittelbarer Kontakt zwischen Substrat und Gegenplatte möglich.

Damit die Strahlung der Energiequellen bis zu den zu prozessierenden Oberflächen durchdringen kann, sind (wie bereits oben angedeutet) die dazwischenliegenden Elemente, wie z. B. Bodenelement und Deckelelement der Prozessbox oder auch die Prozesshaube mindestens teiltransparent ausgebildet, je nach Ausgestaltung der Energiequellen. Zwischen den Substraten und den Strahlungsquellen müssen also (sofern die Energiequellen-Anordnung diese erfordert) etwaige Elemente als teiltransparente oder transparente Scheiben (z. B. aus Glaskeramik) oder als für die gewählte Energiequelle hoch absorbierende Scheiben, die als sekundäre Energiequelle bzw. als Energietransmitter fungieren, ausgebildet sein. Sind die Quellen z. B. im Inneren der Prozesskammer (ggf. auch im Inneren der Prozessbox oder -haube) angeordnet, und liegt auch die Mehrschichtkörperanordnung z. B. in der Prozesskammer, so kann die Kammerwandung (Seitenwände, Deckel und/oder Boden) auch nicht-transparent ausgebildet sein.

Als Material von Boden- und Deckelelement und von ggf. vorhandenen Seitenwandelementen (bei expliziter Prozessbox) oder der Prozesshaube kann bzw. können z. B. Glaskeramik, andere Keramiken, Graphit, Metalle und hochschmelzende Gläser (Auswahl) vorgesehen sein. Auch Siliziumcarbid kann hierfür vorgesehen sein. Auch ein Carrier sollte mindestens teilweise aus teiltransparentem oder hoch absorbierendem Material ausgebildet sein, da er während des Prozessierens in der Anlage verbleiben kann.

Vorzugsweise weist die Vorrichtung zum Positionieren mindestens ein erstes Beabstandungselement auf, das zur Aufnahme des oberen Mehrschichtkörpers und/oder des unteren Mehrschichtkörpers ausgebildet ist, wobei das Beabstandungselement derart mindestens teilweise zwischen den zwei Mehrschichtkörpern anordenbar ist, dass diese beabstandet voneinander anordenbar oder angeordnet sind und so die Mehrschichtkörperanordnung ausbilden. Das Beabstandungselement muss so ausgebildet sein, dass die zu prozessierenden Oberflächen frei für das Prozessgas zugänglich sind, gleichzeitig müssen die Oberflächen derart beabstandet sein, dass sie einen geeigneten Prozessraum ausbilden. Wenn kein Prozessgas zusätzlich zugeführt werden soll oder muss, ist auch ein direkter Kontakt der zu prozessierenden Oberflächen denkbar. Auch dann kann von einem Prozessraum zwischen den zu prozessierenden Oberflächen gesprochen werden.

Da die Mehrschichtkörper vorzugsweise sandwichförmig und damit im Gebrauch horizontal angeordnet sind, lässt sich der obere Mehrschichtkörper auf dem Beabstandungselement ablegen (wird also von dem Beabstandungselement an einem oberen Aufnahmebereich aufgenommen). Der untere Mehrschichtkörper liegt auf dem Beabstandungselement an einem unteren Aufnahmebereich an (das Anlegen wird also auch als Aufnehmen durch das Beabstandungselement verstanden), wobei der untere Aufnahmebereich an einer Seite des Beabstandungselements angeordnet ist, die entgegengesetzt der Seite mit dem oberen Aufnahmebereich liegt.

In einer vorteilhaften Ausführungsform weist die Vorrichtung zum Positionieren mindestens ein zweites Beabstandungselement auf, das zur Aufnahme des oberen Mehrschichtkörpers und/oder des unteren Mehrschichtkörpers und zur Aufnahme des ersten Beabstandungselements ausgebildet ist, derart, dass das zweite Beabstandungselement, der untere Mehrschichtkörper, das erste Beabstandungselement und der obere Mehrschichtkörper sandwichförmig anordenbar oder angeordnet sind und so die Mehrschichtkörperanordnung ausbilden.

Mit dieser Ausgestaltung lässt sich jeder der Mehrschichtkörper tragend durch eines der Beabstandungselemente anordnen, wobei die Beabstandungselemente dann übereinander stapelbar sind. Das heißt, das untenliegende zweite Beabstandungselement wird vor dem Prozess an einer geeigneten Stelle platziert (in der Prozesskammer oder -box, auf dem Carrier etc.) und zuerst mit dem untenliegenden Substrat bzw. Mehrschichtkörper beladen, Precursor-Schichtseite nach oben, danach wird das erste Beabstandungselement aufgesetzt, gefolgt von der Beladung mit dem obenliegenden Substrat bzw. Mehrschichtkörper, Precursor-Schichtseite nach unten (Beladung zur Ausbildung einer Mehrschichtkörperanordnung). Diese Anordnung erleichtert den Zusammenbau einer Mehrschichtkörperanordnung. Die Entladung nach der Prozessierung erfolgt entsprechend in umgekehrter Reihenfolge.

Das erste Beabstandungselement lässt sich grundsätzlich auch so ausgestalten, dass es nicht auf dem zweiten Beabstandungselement aufliegt, sondern ebenfalls auf der "geeigneten Stelle", also z. B. auf dem Carrier.

Die Unterseite (Unterseite im Gebrauch) des untenliegenden zweiten Beabstandungselements kann bei diesem Konzept auch als Auflagefläche zum Transport (z. B. durch Rollenantrieb) dienen. Das zweite oder untere Beabstandungselement kann auch selbst die Funktion eines Carriers übernehmen.

Die Beabstandungselemente können auch als Auflageelemente bezeichnet werden, das erste Beabstandungselement als erstes Auflageelement, das zweite Beabstandungselement als zweites Auflageelement. Auflageelemente deshalb, weil die Substrate bzw. Mehrschichtkörper an diesen anliegen bzw. aufliegen.

Vorzugsweise ist das zweite Beabstandungselement im Gebrauch mindestens teilweise unter dem unteren Mehrschichtkörper anordenbar. Somit ist ein sicherer Halt des Substrats gewährleistet.

In einer vorteilhaften Ausführungsform weisen das erste Beabstandungselement und das zweite Beabstandungselement jeweils mindestens einen Auflagebereich auf, auf welchen oder an welchen der oder die Mehrschichtkörper auflegbar oder anlegbar ist oder sind.

Beim Lagern der Substrate ist darauf zu achten, dass die beschichteten Seiten möglichst wenig berührt werden, um eine Kontamination durch Berühren oder die Störung der Prozessgasatmosphäre an der Kontaktfläche zu vermeiden (damit die Schichtqualität des entstehenden Absorbers nicht lokal oder integral beeinträchtigt wird). Diese Anforderung wird zum Teil dadurch erleichtert, dass z. B. 15 mm des Randbereichs von jeder Kante in einem späteren Prozessschritt sowieso entfernt werden und daher nicht zur aktiven Schicht gehören.

Vorzugsweise weisen das erste Beabstandungselement und/oder das zweite Beabstandungselement jeweils mindestens ein Rahmenelement und/oder ein Rahmenleistenelement auf, so dass die Mehrschichtkörper vorzugsweise an deren Kantenbereichen (am Rand) mindestens teilweise auf das Rahmenelement und/oder das Rahmenleistenelement auflegbar oder an das Rahmenelement und/oder das Rahmenleistenelement anlegbar sind. Die Rahmenelemente bzw. Rahmenleistenelemente ermöglichen einen möglichst geringen Kontakt der Mehrschichtkörper, also z. B. der Substrate, mit diesen (also mit den Rahmenelementen), um die zu prozessierenden Oberflächen möglichst frei zu halten.

Eine vorteilhafte Ausführungsform sieht vor, dass die zwei Mehrschichtkörper und das erste Beabstandungselement oder die zwei Mehrschichtkörper und das erste Beabstandungselement und das zweite Beabstandungselement derart zueinander angeordnet sind, dass sie einen im Wesentlichen geschlossenen, also quasi-geschlossenen Prozessraum ausbilden, im Sinne einer Abgrenzung von reaktiver Dünnschicht und Ofenumgebung bzw. Kammerraum. Das heißt, die Substrate bilden Deckelelement und Bodenelement einer Prozessbox, während das oder die Beabstandungselemente z. B. als Seitenwandelemente der Prozessbox vorgesehen sind. Das Mehrschichtkörper-Sandwich stellt in diesem Fall ein Analogon zu einer expliziten Prozessbox dar. Der Prozessraum ist damit in gewünschter Weise reduziert, lediglich die zu prozessierenden Oberflächen werden dem Prozessgas ausgesetzt.

In dieser dargelegten Prozess-Variante wird versucht, durch eine Minimierung der Kammer-Umgebung einen ausreichend hohen (z. B.) Se-Partialdruck auch ohne Einsatz einer expliziten Prozessbox zu gewährleisten.

Meist sind die Mehrschichtkörper rechteckförmig oder quadratisch ausgebildet. Vorzugsweise sind dann auch das erste Beabstandungselement und/oder das zweite Beabstandungselement vorzugsweise im Wesentlichen die Konturen der Mehrschichtkörper nachbildend ebenfalls rechteckförmig oder quadratisch ausgebildet und weisen so jeweils mindestens ein rechteckförmig oder quadratisch ausgebildetes Rahmenelement auf.

Mit dieser Ausgestaltung liegen die Substrate dann an ihren Kanten auf den jeweiligen Rahmenelementen auf, so dass die zu beschichtenden bzw. die zu prozessierenden Oberflächen frei bleiben. Es ist darauf zu achten, dass die Mehrschichtkörper über eine ausreichend große Auflagefläche auf dem Beabstandungselement aufliegen bzw. an diesem anliegen.

In einer weiteren Ausführungsform weisen das erste Beabstandungselement und/oder das zweite Beabstandungselement zwei Rahmenleistenelemente (Leisten) auf, die sich in einer Erstreckungsebene der Mehrschichtkörper im Gebrauch gegenüberliegen, so dass die Mehrschichtkörper vorzugsweise an deren Kantenbereichen, z. B. an deren Längsseiten, mindestens teilweise auf die Rahmenleistenelemente auflegbar oder an die Rahmenleistenelemente anlegbar sind, so dass z. B. an den Querseiten der Mehrschichtkörperanordnung jeweils mindestens ein Öffnungsbereich zum Zuführen und/oder Abführen des Prozessgases in den und/oder aus dem Prozessraum ausgebildet ist. Die Anordnung kann auch umgekehrt ausgeführt sein, d. h. an den Längsseiten der Mehrschichtkörperanordnung ist jeweils mindestens ein Öffnungsbereich zum Zuführen und/oder Abführen des Prozessgases in den und/oder aus dem Prozessraum ausgebildet. Das heißt, es liegen sich vorzugsweise mindestens zwei Öffnungsbereiche gegenüber, an denen keine Rahmenleistenelemente vorgesehen sind. Bei quadratisch ausgebildeten Substraten wird nicht zwischen Längs- und Querseiten unterschieden.

Möglich ist es auch, die Rahmenleistenelemente derart auszubilden, dass sie sich jeweils um mindestens zwei sich diagonal gegenüberliegende Ecken der Mehrschichtkörperanordnung erstrecken. Die übrigen offenen Bereiche, die dann sowohl an den Längs- als auch an den Querseiten der Anordnung vorgesehen sind, dienen dem Gasaustausch.

Der so gebildete Prozessraum ist ein quasi-offener und ermöglicht eine schnelle Prozessgaszu- oder auch -abfuhr. Mit quasi-offen ist in diesem Zusammenhang also das Ermöglichen eines partiellen Gasaustauschs zwischen Substrat-Umgebung und Ofen (-Kammer)-Umgebung gemeint.

Wie bereits oben beschrieben, sollen die Mehrschichtkörper mindestens teilweise auf den Auflagebereichen der Beabstandungselemente aufliegen oder an diesen anliegen. Sofern die Mehrschichtkörper entlang ihren Konturen vollständig aufliegen, lässt sich ein im Wesentlichen geschlossener Prozessraum ausbilden. Bei teilweisem Aufliegen sind Öffnungsbereiche vorgesehen, die einen Austausch des Prozessgases mit der Atmosphäre im Kammerraum ermöglicht. Bei Rahmenleistenelementen, die z. B. nur an den Längsseiten der Substrate angeordnet sind, sind diese Öffnungsbereiche ohnehin gegeben. Verschiedene Ausführungsformen sind also vorstellbar, die zu einem quasi-offenem Rahmen führen.

Die Variante "quasi-offener Prozessraum" ist insbesondere für das Tunnel- und Hauben-Konzept der RTP-Prozessierung von Interesse (Prozessgas-Zufuhr zu den Precursorschichten als den zu prozessierenden Oberflächen des Substrat-Sandwichs in der Haube bzw. im Tunnel).

Bei einer Anordnung der Rahmenelemente oder Rahmenleistenelemente an den Mehrschichtkörperkanten bzw. Substratkanten entlang der Transportrichtung ist es denkbar, die Rahmenelemente oder Rahmenleistenelemente derart zu gestalten, dass eine Führung des Substrat-Sandwichs in Transportrichtung erfolgen kann.

Insbesondere bei quasi-geschlossenen Systemen muss eine andere Möglichkeit zum Zu- und Abführen des Prozessgases vorgesehen werden. Im RTP-Prozess können z. B. die Prozessgase H₂, N₂, Ar, H₂S, H₂Se, S-Gas, Se-Gas eingesetzt und zu gezielten Prozesszeiten ins Ofeninnere also in den Kammerraum bzw. ins Innere der Prozessbox eingeleitet werden. Möglich ist es also auch, den Sulfurisierungsprozess mit gasförmigem Schwefel (S) bzw. den Selenisierungsprozess mit gasförmigem Selen (Se) durchzuführen. Um die Prozessgas-Zufuhr zum Dünnschicht-Precursor (also den Mehrschichtkörper) im hier dargelegten Aufbau während des RTP-Prozesses zu ermöglichen, wird eine Prozessgas-Zufuhr über den Rahmen vorgeschlagen.

Im Selenisierungsprozess wird das im Precursor vorliegende Selen unter Prozessgasatmosphäre umgewandelt, so dass die gewünschte Halbleiterstruktur erhalten wird. Möglich ist es auch, zusätzlich Selen im Prozessgas vorzusehen (Se-Gas), je nach gewünschtem Ergebnis. Die Umwandlung des Precursor-Selens ist aber auch ohne explizites Selen im Prozessgas möglich.

Vorzugsweise weisen daher das erste Beabstandungselement und/oder das zweite Beabstandungselement ein Gaszufuhrelement und/oder Gasabfuhrelement zum Zuführen und/oder Abführen eines Prozessgases in den und/oder aus dem Prozessraum auf. Das Gaszufuhrelement bzw. Gasabfuhrelement kann beispielsweise als ein in das erste Beabstandungselement und/oder das zweite Beabstandungselement integrierter Gasverteiler-Kamm mit mindestens einem Anschlusselement zum Anschließen einer Gaszuführleitung und/oder Gasabführleitung ausgebildet sein.

In diesem Falle erfolgt die Prozessgaszufuhr (und auch -abfuhr) also über das oder die Beabstandungselemente (partieller bzw. anpassbarer Gasaustausch zwischen Ofenumgebung (z. B. Hauben-, Tunnelumgebung) und Precursor-Dünnschicht). Die Ausbildung des Kammes und der Andockelemente bzw. -stößel lässt sich variabel gestalten, beispielsweise hinsichtlich der Anzahl der Gasauslässe ("Kammzähne"). So kann das entsprechende Beabstandungselement z. B. hohl und mit Öffnungen für den Gasauslass (oder -einlass) ausgebildet sein. Über das Anschlusselement (oder die Anschlusselemente) sind dann entsprechende Leitungen anschließbar, über die das Gas zugeführt oder auch wieder abgeführt werden kann.

An sich können die Gasverteiler auch anderweitig an der Kammer und/oder der Prozessbox bzw. -haube angeordnet werden. Wichtig ist es, ein im Wesentlichen homogenes Einleiten des Prozessgases von einer Gasquelle, z. B. einer externen Gasquelle, hin zu den Substraten (über die Prozesskammer oder den Prozesstunnel oder unter Umgehung der Prozesskammer oder des Prozesstunnels nur in eine ggf. vorhandene Prozessbox oder -haube) zu ermöglichen, so dass es zu einer möglichst laminaren Gasströmung über die Substratoberfläche von z. B. einer Längskante zur anderen kommt. Die Gaszufuhr kann an vorgegebenen Einlässen der Gasverteiler zu beliebigen Zeiten des Temperprofiles gesteuert werden. Verbrauchte Mengen des Prozessgases können so nachgeladen werden und/oder nicht mehr erwünschter überschüssiger (z. B.) Selendampf (und/oder sonstige Komponenten des Dampfes) kann aus der Reaktionskammer zum richtigen Zeitpunkt verdrängt werden.

Während der RTP-Prozessierung muss ggf. mit einer Substratverbiegung gerechnet werden, da insbesondere das obenliegende Substrat quasi schwebend gelagert ist (wenn es nicht unmittelbar auf dem unteren Substrat aufliegt). Es ist vorstellbar dass es bei hohen Prozess-Temperaturen zu Durchbiegungen kommt, die sich nach der Prozessierung in Substratverbiegungen manifestieren.

In einer vorteilhaften Ausgestaltung weisen daher das erste Beabstandungselement und/oder das zweite Beabstandungselement jeweils mindestens ein Querverbindungselement auf, zum Verbinden von, in der Erstreckungsebene der Mehrschichtkörper sich gegenüberliegenden Bereichen des jeweiligen Rahmenelements oder von sich im Gebrauch gegenüberliegenden Rahmenleistenelementen, so dass der oder die Mehrschichtkörper zur Vermeidung einer Durchbiegung zusätzlich abstützbar ist oder sind.

Die Querstreben dienen zugleich der Stabilisierung des Rahmens bzw. des Rahmenelements oder der Rahmenleistenelemente. Beim Design der Querstreben bzw. Querverbindungselemente ist auf eine minimale Breite zu achten (jedoch ausreichend, um die gewünschte Stabilität zu gewährleisten), um eine Abschattung der Strahlung der (Heiz-)Strahler bzw. der Energiequellen zu minimieren.

Da das Querverbindungselement sich im Wesentlichen "quer" über die zu prozessierende Oberfläche ziehen kann, sollte der Kontakt zwischen Querverbindungselement und Oberfläche möglichst gering gehalten werden. Hierfür kann das Querverbindungselement mindestens ein Abstützelement aufweisen, so dass die Mehrschichtkörper auf dem oder an dem Querverbindungselement über das Abstützelement auflegbar oder anlegbar sind, wobei das Abstützelement derart ausgebildet ist, dass es dieselbe Höhe wie das jeweilige mindestens eine Rahmenelement oder Rahmenleistenelement aufweist (planes Aufliegen der Substrate auf dem oder den Rahmen(leisten)element(en) und dem Abstützelement).

Vorzugsweise ist das Abstützelement als Punktstützenelement, vorzugsweise als Kugelelement ausgebildet. Somit ist eine möglichst kleine Auflagefläche oder auch Anlagefläche gewährleistet. Eine noch geringere Abschattung wird durch nadelförmige Elemente erreicht.

In einer bevorzugten Ausgestaltung der Erfindung weist das mindestens eine Rahmenelement oder Rahmenleistenelement (bzw. weisen die Rahmenleistenelemente) mindestens zwei Abstützelemente derart auf, dass die Mehrschichtkörper auf den oder an den Abstützelementen auflegbar oder anlegbar sind, so dass an den Querseiten und/oder Längsseiten der Mehrschichtkörperanordnung jeweils mindestens ein Öffnungsbereich zum Zuführen und/oder Abführen des Prozessgases in den und/oder aus dem Prozessraum ausgebildet ist. Das heißt, auch an dem Rahmenelement oder dem Rahmenleistenelement kann der Auflagebereich reduziert werden, wenn diese(s) mit den Abstützelementen ausgebildet ist bzw. sind.

Dieser Ansatz führt wiederum zu einem quasi-offenen Rahmendesign mit den bereits oben aufgeführten Kombinationsmöglichkeiten mit dem Tunnel- oder Hauben-RTP-Konzept (Prozessgas-Zufuhr durch die Umgebung). Denkbare Vorteile dieses Abstützelement-Konzepts, also z. B. eines Punktstützenelement-Konzepts, gegenüber dem oben beschriebenen Rahmenelementen bzw. Rahmenleistenelementen ohne Abstützelemente sind die geringere Kontaktflächen mit den Substraten und damit eine Verringerung evtl. auftretender lokaler Störungen. Zudem ist eine Verringerung von Substratverbiegung durch die Einbringung von Stützpunkten im Substrat-Inneren gegeben.

Vorzugsweise ist das erste und/oder zweite Beabstandungselement aus Graphit oder Quarzglas ausgebildet, auch Glaskeramik, andere Keramiken und hochschmelzende Gläser sind denkbar.

Das Rahmenmaterial sollte inert sein, beständig in korrosiver Umgebung (S-, Sehaltig) und mechanisch stabil. Aufgrund des direkten Kontaktes mit den Substraten sind auch die Wärmeleitfähigkeit und der thermische Ausdehnungskoeffizient zu betrachten, um laterale Inhomogenitäten der Temperaturverteilung auf dem Substrat weitestgehend zu vermeiden und Schichtabplatzungen bzw. Schädigungen zu verhindern.

Rahmenmaterial und auch Abstützelemente können aus Graphit oder Quarzglas, Glaskeramik, andere Keramiken oder hochschmelzenden Gläsern ausgebildet sein (z. B. Graphitkugeln). Auch bei der Auswahl des Materials für die Punktstützen ist auf folgende Materialeigenschaften zu achten: inertes Material, Korrosionsbeständigkeit, mechanische Stabilität, thermische Leitfähigkeit und thermischer Ausdehnungskoeffizient. Der Einsatz von z.B. Graphit-Kugeln in Kombination mit einem Graphit-Rahmenelement bzw. -Rahmenleistenelement ist beispielsweise denkbar.

Selbstständiger Schutz wird beansprucht für eine Anordnung, insbesondere Mehrschichtkörperanordnung, umfassend
- mindestens zwei Gegenstände, insbesondere mindestens zwei Mehrschichtkörper, mit jeweils mindestens einer zu prozessierenden Oberfläche,
- mindestens eine Vorrichtung zum Positionieren der mindestens zwei Gegenstände, so wie sie oben beschrieben ist.

Selbstständiger Schutz wird auch beansprucht für eine Anordnung, insbesondere Mehrschichtkörperanordnung, umfassend mindestens zwei Gegenstände, insbesondere mindestens zwei Mehrschichtkörper, mit jeweils mindestens einer zu prozessierenden Oberfläche, wobei die mindestens zwei Gegenstände, insbesondere die mindestens zwei Mehrschichtkörper derart angeordnet sind, dass sich die jeweils zu prozessierenden Oberflächen gegenüberliegen und die Gegenstände, insbesondere Mehrschichtkörper, so einen zwischen den Oberflächen angeordneten Prozessraum ausbilden, in dem im Wesentlichen die Prozessierung erfolgt.

Mit dieser Anordnung kann auf eine explizite Vorrichtung zum Positionieren verzichtet werden, vielmehr liegen die Substrate mit ihren zu prozessierenden Oberflächen aufeinander, z. B. in der Prozessbox oder auch in der Prozesskammer. Diese Anordnung ist insbesondere dann geeignet, wenn kein Prozessgas für die Prozessierung in den Raum zwischen den zu prozessierenden Oberflächen zugeführt werden muss.

Die Vorrichtung zum Positionieren ist in die Prozesskammer einführbar und aus dieser wieder entfernbar. Die Mehrschichtkörperanordnung ist zweckmäßigerweise außerhalb der Prozessieranlage aufzubauen und anschließend in die Anlage zu transportieren oder auch manuell einzubringen, damit sie dort dem gewünschten Prozess (z. B. der Selenisierung der Substrate) unterzogen werden kann. Möglich ist es auch, die Vorrichtung zum Positionieren derart in der Prozesskammer anzuordnen, dass sich in dieser die Mehrschichtkörperanordnung aufbauen lässt. Auch können die Mehrschichtkörper ohne die Vorrichtung angeordnet werden. Nach der Umwandlung der Substrate zu den gewünschten Chalkopyrit-Halbleitern ist die Anordnung im Gesamten aus dem Kammerraum entfernbar oder die Einzelteile sind entnehmbar.

Selbstständiger Schutz wird auch beansprucht für eine Anlage zum Prozessieren, insbesondere zum Selenisieren, von mindestens zwei Gegenständen, insbesondere von mindestens zwei Mehrschichtkörpern, mit jeweils mindestens einer zu prozessierenden Oberfläche, umfassend
- mindestens eine Prozesskammer mit einem Kammerraum (oder auch Tunnel mit Tunnelraum),
- eine Vorrichtung zum Positionieren der mindestens zwei Gegenstände, so wie sie oben beschrieben ist.

Vorzugsweise weist die Anlage mindestens eine Energiequelle zum Aufheizen der Mehrschichtkörper auf. Vorzugsweise ist die Energiequelle derart an der Prozesskammer bzw. in der Prozessieranlage angeordnet, dass jeder der Mehrschichtkörper jeweils von der Seite aus beheizt wird, die der zu prozessierenden Oberfläche abgewandt angeordnet ist (Substratrückseite(n)). Hierfür können z. B. zwei Energiequellen vorgesehen sein, eine für den unteren Mehrschichtkörper, eine für den oberen Mehrschichtkörper (das heißt, mindestens jeweils eine Energiequelle ist für jeden der Mehrschichtkörper vorgesehen). Damit lassen sich die Mehrschichtkörper, also z. B. die Substrate, über ihre Rückseiten aufheizen, also über die Seiten, die jeweils den zu prozessierenden Oberflächen abgewandt angeordnet sind.

Die Ausgestaltung der Energiequellen ist variierbar. Wie bereits oben beschrieben, erfolgt die Aufheizung der Substrate bzw. der Mehrschichtkörper im Wesentlichen nur einseitig durch das Heizen der jeweiligen Mehrschichtkörperrückseite bzw. Glasrückseite. Das obere Substrat wird nur von oben, das untere wird nur von unten geheizt. Eine direkte Aufheizung der sich gegenüberliegenden beschichteten Oberflächen findet nicht statt. Demgemäß muss bei der Wahl der Energiequelle darauf geachtet werden, dass ausreichend Wärme an den zu prozessierenden Oberflächen zur Verfügung steht (Aufheizrate), denn der Teil des Spektrums der Strahlungsquelle, der schon im Substratglas absorbiert wird, erreicht die Schicht erst durch Wärmeleitung etwas verzögert. Je höher der Anteil der Leistung der erst im Molybdän absorbiert wird, desto größer sind die erreichbaren Aufheizraten. Das Substratglas absorbiert z. B. bei Wellenlängen oberhalb ca. 1,5 µm und unterhalb 350 nm.

Durch einseitiges Aufheizen könnte die Scheibe brechen oder eine übermäßige Verbiegung aufweisen. Da die Dicke des Glases nur 2-3 mm beträgt und ein großer Anteil der Strahlung erst im Mo absorbiert wird, ist nicht zu erwarten, dass bei Aufheizraten im Bereich von einigen K/s vertikale Gradienten im Glas aufgebaut werden können. Viel wichtiger für geringe Bruchraten ist die laterale Homogenität des Aufheizens (in der Substratfläche). Entsprechend ist die Energiequelle vorzusehen. Auch beim Abkühlen ist es erfahrungsgemäß sehr wichtig, die laterale Homogenität zu optimieren. Bei den in dieser Anordnung erreichbaren Abkühlraten, ist es nicht zu erwarten, dass Spannungen im Glas durch vertikale Gradienten zwischen Schichtseite (also beschichteter Seite) und Rückseite entstehen können.

Eine bevorzugte Ausgestaltung sieht vor, dass mindestens eine Einrichtung zum Ausbilden eines reduzierten Kammerraums vorgesehen ist, die in der Prozesskammer anordenbar oder angeordnet ist, vorzugsweise eine Prozessbox oder eine Prozesshaube. Derartige Einrichtungen reduzieren den eigentlichen Raum, der für die Prozessierung zur Verfügung steht und bilden einen expliziten Prozessraum aus.

Vorteilhafterweise weist die Prozessbox mindestens ein Deckelelement und mindestens ein Bodenelement auf, zwischen welchen die mindestens zwei Mehrschichtkörper anordenbar sind. In diesem Falle kann der untere Mehrschichtkörper auf dem Bodenelement aufgelegt werden, auf diesen wird dann zumindest ein Beabstandungselement, vorzugsweise ein Rahmenelement oder zwei Rahmenleistenelemente aufgelegt und auf das Beabstandungselement wiederum der obere Mehrschichtkörper. Mittels des Deckelelements wird die Prozessbox verschlossen. Damit ist die Mehrschichtkörperanordnung definiert in der Prozesskammer der Anlage untergebracht.

Mit zusätzlichen Seitenwandelementen kann die Prozessbox im Wesentlichen vollständig geschlossen werden. Etwaige offene Bereiche könnten dem Gasaustausch dienen.

Die Prozessbox ist in die Prozesskammer einführbar und aus dieser wieder entfernbar.

Die Einrichtung zum Ausbilden eines reduzierten Kammerraums kann auch als Prozesshaube ausgebildet sein. Dabei ist die Prozesshaube z. B. als stationär in der Behandlungskammer angeordneter Deckel ausgebildet. Der Gasaustausch zwischen Prozessraum und Kammerraum ist daher deutlich reduzierbar. Auch kann der Prozessraum unter Umgehung des Kammerraums unmittelbar mit einer (z. B. externen) Gasquelle in Verbindung stehen.

Wie bereits oben beschrieben, kann die Prozessbox zumindest teilweise auch durch die Mehrschichtkörperanordnung ausgebildet werden.

Die Materialien sind wie z. B. oben beschrieben gewählt.

Verfahrensmäßig wird die oben genannte Aufgabe durch einVerfahren zum Positionieren von mindestens zwei Gegenständen, insbesondere von mindestens zwei Mehrschichtkörpern mit jeweils mindestens einer zu prozessierenden Oberfläche gelöst, mittels einer Vorrichtung zum Positionieren der mindestens zwei Gegenstände, insbesondere Mehrschichtkörper, die zur Aufnahme der mindestens zwei Gegenstände, insbesondere der Mehrschichtkörper, ausgebildet ist, wobei das Verfahren folgende Schritte umfasst:
- Anordnen der Vorrichtung an einer dafür vorgesehenen Stelle,
- Anordnen der zwei Gegenstände, insbesondere der zwei Mehrschichtkörper, an der Vorrichtung derart, dass sich die jeweils zu prozessierenden Oberflächen gegenüberliegen und die Gegenstände, insbesondere Mehrschichtkörper, so einen zwischen den Oberflächen angeordneten Prozessraum ausbilden, in dem im Wesentlichen die Prozessierung erfolgt, so dass die mindestens zwei Gegenstände als eine Mehrschichtkörperanordnung in einer Prozessieranlage prozessierbar, insbesondere selenisierbar sind.

Es wird angemerkt, dass das erfindungsgemäße Verfahren auch durch Merkmale der Vorrichtung gemäß der abhängigen Ansprüche vorgesehen werden kann.

Vorzugsweise ist der weitere Schritt vorgesehen: Anordnen der Vorrichtung in einer Prozesskammer oder einem Prozesstunnel der Prozessieranlage mit einem Kammerraum und/oder in einer Einrichtung zum Ausbilden eines reduzierten Kammerraums und/oder auf oder an einem Tragelement zum Transportieren der Mehrschichtkörperanordnung mittels einer Transportvorrichtung in die Prozessieranlage (d. h. in die Prozesskammer oder in den Prozesstunnel) und aus dieser heraus oder an einer sonstigen geeigneten Stelle.

In einer vorteilhaften Ausgestaltung des Verfahrens kann der Schritt des Anordnens der Vorrichtung folgendermaßen vorgesehen sein:
- Anordnen in einer Prozessbox mit einem Bodenelement, einem Deckelelement und vorzugsweise mit Seitenwandelementen als die Einrichtung zum Ausbilden eines reduzierten Kammerraums oder
- Anordnen innerhalb bzw. unter einer Prozesshaube, die insbesondere zum stationären Verbleib in der Prozessieranlage ausgebildet ist, als die Einrichtung zum Ausbilden eines reduzierten Kammerraums.

Vorzugsweise umfasst das Verfahren den Schritt des Anordnens der zwei Mehrschichtkörper im Gebrauch an der Vorrichtung zum Positionieren sandwichförmig übereinanderliegend, so dass ein unterer Mehrschichtkörper und ein oberer Mehrschichtkörper vorgesehen sind. Die im Gebrauch "horizontal" liegenden Körper können so am gleichmäßigsten und am sichersten prozessiert werden.

Vorzugsweise ist der weitere Schritt vorgesehen: Anordnen der zwei Mehrschichtkörper derart an der Vorrichtung oder in dem Kammerraum der Prozesskammer bzw. im Tunnel der Prozessieranlage (oder an einer sonstigen dafür vorgesehenen Stelle), dass die zwei Mehrschichtkörper und/oder die Vorrichtung zum Positionieren mindestens teilweise die Einrichtung zum Ausbilden eines reduzierten Kammerraums, vorzugsweise eine Prozessbox, ausbilden.

In einer vorteilhaften Ausgestaltung umfasst das Verfahren die folgenden weiteren Schritte:
- Anordnen des oberen Mehrschichtkörpers und/oder des unteren Mehrschichtkörpers an einer hierfür vorgesehenen Stelle,
- Anordnen mindestens eines ersten Beabstandungselements, welches von der Vorrichtung zum Positionieren umfasst ist (also Teil der Vorrichtung zum Positionieren ist), derart mindestens teilweise zwischen den zwei Mehrschichtkörpern, dass diese beabstandet voneinander angeordnet sind und so die Mehrschichtkörperanordnung ausbilden.

Weiterhin umfasst das Verfahren in einer vorteilhaften Ausgestaltung folgende zusätzlichen Schritte:
- Anordnen mindestens eines zweiten Beabstandungselements, welches von der Vorrichtung zum Positionieren umfasst ist (also Teil der Vorrichtung zum Positionieren ist), an einer hierfür vorgesehenen Stelle,
- Anordnen des unteren Mehrschichtkörpers an dem zweiten Beabstandungselement,
- Anordnen des ersten Beabstandungselements an dem zweiten Beabstandungselement,
- Anordnen des oberen Mehrschichtkörpers an dem ersten Beabstandungselement,

so dass das zweite Beabstandungselement, der untere Mehrschichtkörper, das erste Beabstandungselement und der obere Mehrschichtkörper sandwichförmig angeordnet sind und so die Mehrschichtkörperanordnung ausbilden.

Das erste Beabstandungselement kann ggf. auch unmittelbar auf der hierfür vorgesehenen Stelle angeordnet werden, z. B. in dem Kammerraum, auf dem Bodenelement einer Prozessbox oder auf einem Carrier. Hierfür müsste das erste Beabstandungselement entsprechend ausgelegt sein.

Wie bereits oben beschrieben, lässt sich die Mehrschichtkörperanordnung außerhalb der Prozessieranlage aufbauen, z. B. in der Prozessbox, die beispielsweise mit dem Tragelement tranportiert wird oder unmittelbar auf dem Tragelement. Mittels des Tragelements lässt sich die Anordnung dann in die Prozessieranlage fahren. Möglich ist es auch, die Anordnung ohne Tragelement zu transportieren, z. B. mit einem Rollenantrieb. Auch das manuelle Einführen der Anordnung (sowohl der einzelnen Bauteile, als auch der gesamten, vorab zusammengebauten Anordnung) in die Prozessieranlage ist möglich. Im Übrigen kann auch das untere Beabstandungselement als Tragelement und/oder Transportelement dienen.

Ferner ist es vorgesehen, die positionierten Mehrschichtkörper in die Prozessieranlage einzubringen, zu prozessieren und wieder aus der Anlage zu entfernen. Dies ist z. B. mittels der bereits beschriebenen Transportvorrichtung möglich oder auch manuell.

Selbstständiger Schutz wird auch beansprucht für ein Verfahren zum Positionieren von mindestens zwei Gegenständen, insbesondere von mindestens zwei Mehrschichtkörpern mit jeweils mindestens einer zu prozessierenden Oberfläche, wobei das Verfahren folgenden Schritt umfasst:
Anordnen der zwei Gegenstände, insbesondere der zwei Mehrschichtkörper derart,
dass sich die jeweils zu prozessierenden Oberflächen gegenüberliegen und die Gegenstände, insbesondere Mehrschichtkörper, so einen zwischen den Oberflächen angeordneten Prozessraum ausbilden, in dem im Wesentlichen die Prozessierung erfolgt, so dass die mindestens zwei Gegenstände als eine
Mehrschichtkörperanordnung in einer Prozessieranlage prozessierbar, insbesondere selenisierbar sind.

Konkret heißt dies z. B. Anordnen des unteren Mehrschichtkörpers in der Prozesskammer, in der Prozessbox, auf einem Carrier oder an einer sonstigen geeigneten Stelle und Auflegen des oberen Mehrschichtkörpers auf den unteren, so dass sich die zu prozessierenden Oberflächen gegenüberliegen. Von einem Prozessraum kann auch gesprochen werden, wenn die Substrate unmittelbar aufeinander liegen.

Mit den soeben beschriebenen Verfahrensschritten zum Zusammenbau der Mehrschichtkörperanordnung können die Mehrschichtkörper bzw. Substrate präzise gelagert werden, so dass deren Prozessierung in einer entsprechenden Anlage mit hohem Durchsatz und auf effiziente Weise durchgeführt werden kann.

Im Übrigen und für weitere Details wird auch bezüglich des Verfahrens auf die Ausführungen zu der entsprechenden Vorrichtung zum Positionieren der Gegenstände verwiesen.

Weitere Ausführungsformen der Erfindung ergeben sich aus den Unteransprüchen.

Nachfolgend wird die Erfindung anhand von Ausführungsbeispielen beschrieben, die anhand der Abbildungen näher erläutert werden. Hierbei zeigen:
- Fig. 1 eine erfindungsgemäßen Anordnung (prinzipielle Darstellung) in einer perspektivischen Ansicht;
- Fig. 2 eine Ausführungsform einer Vorrichtung zum Positionieren bzw.
   Anordnung in einer perspektivischen Ansicht;
- Fig. 3 ein Beabstandungselement wie in Fig. 2 vorgesehen, in einer perspektivischen Ansicht;
- Fig. 4 ein weiteres Beabstandungselement in einer perspektivischen Ansicht;
- Fig. 5 ein weiteres Beabstandungselement in Draufsicht;
- Fig. 6 ein weiteres Beabstandungselement in einer perspektivischen Ansicht;
- Fig. 7 das Beabstandungselement gemäß Fig. 2 oder 3 in einer perspektivischen Ansicht;
- Fig. 8 ein weiteres Beabstandungselement in einer perspektivischen Ansicht;
- Fig. 9 eine weitere Ausführungsform der Vorrichtung bzw. Anordnung in einer Schnittdarstellung;
- Fig. 10 eine weitere Ausführungsform der Vorrichtung bzw. Anordnung in einer Schnittdarstellung;
- Fig. 11 die Ausführungsform der Vorrichtung bzw. Anordnung gemäß Fig. 2 in einer Prozessbox, in einer perspektivischen Ansicht;
- Fig. 12 eine weitere Ausführungsform der Anordnung in einer Prozesskammer, in einer perspektivischen Ansicht;
- Fig. 13 eine weitere Ausführungsform der Anordnung in einer Prozesskammer, in einer perspektivischen Ansicht;
- Fig. 14 eine Anlage zum Prozessieren in einer Schnittdarstellung.

In der nachfolgenden Beschreibung werden für gleiche und gleich wirkende Teile dieselben Bezugsziffern verwendet.

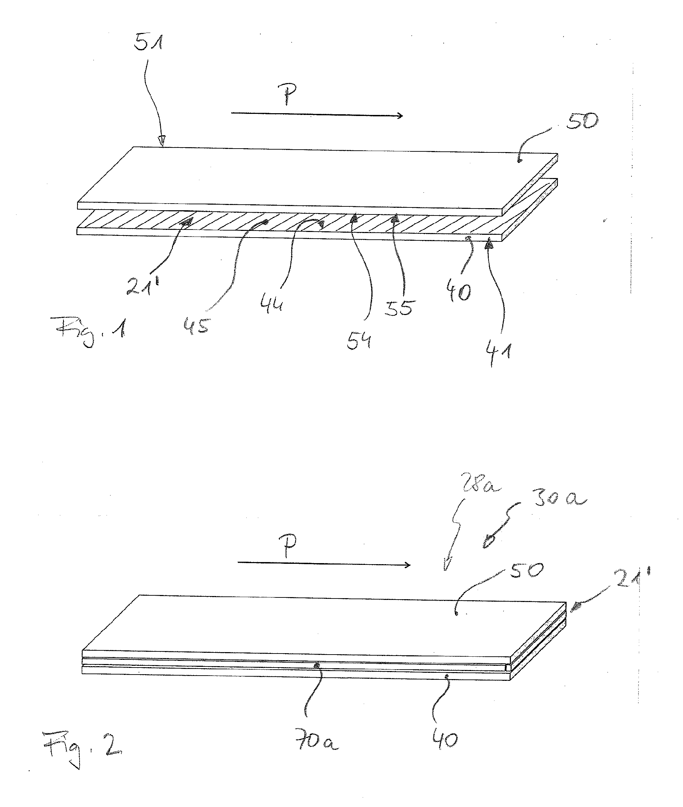

In Fig. 1 ist eine Anordnung zweier Gegenstände gezeigt, wie sie mit einer erfindungsgemäßen Vorrichtung herstellbar ist. Die Gegenstände sind als Mehrschichtkörper, hier als Substrate 40, 50 ausgebildet, die zum Prozessieren, insbesondere zum Selenisieren, vorgesehen sind. Die Substrate weisen an einer Oberfläche 44, 54 eine Beschichtung (Precursor) 45, 55 auf (zu prozessierende Oberflächen). Die Beschichtung (Schichtpaket bestehend z. B. aus Kupfer, Indium und Gallium sowie einer abschließenden Bedeckung aus elementarem Selen, Precursor) soll in einer Prozesskammer mit relativ hohen Aufheizraten von bis zu einigen K/s auf höhere Temperaturen gebracht werden, so dass die zuvor aufgetragenen Einzelkomponenten zur Halbleiterverbindung reagieren (schnelle thermische Prozessierung, Rapid Thermal Processing, RTP, von Schichtstapel-Vorläuferschichten, SEL-Precursor, Stacked Elemental Layer). So lassen sich Dünnschichthalbleiter herstellen, beispielsweise Dünnschichtsolarzellen bzw. -module. Solarstromanlagen werden z. B. mit Solarmodulen auf der Basis von Chalkopyrit-Halbleitern (z. B. CuInSe₂, abgekürzt "CIS" oder Cu(In,Ga)(S,Se)₂, abgekürzt "CIGSSE") betrieben.

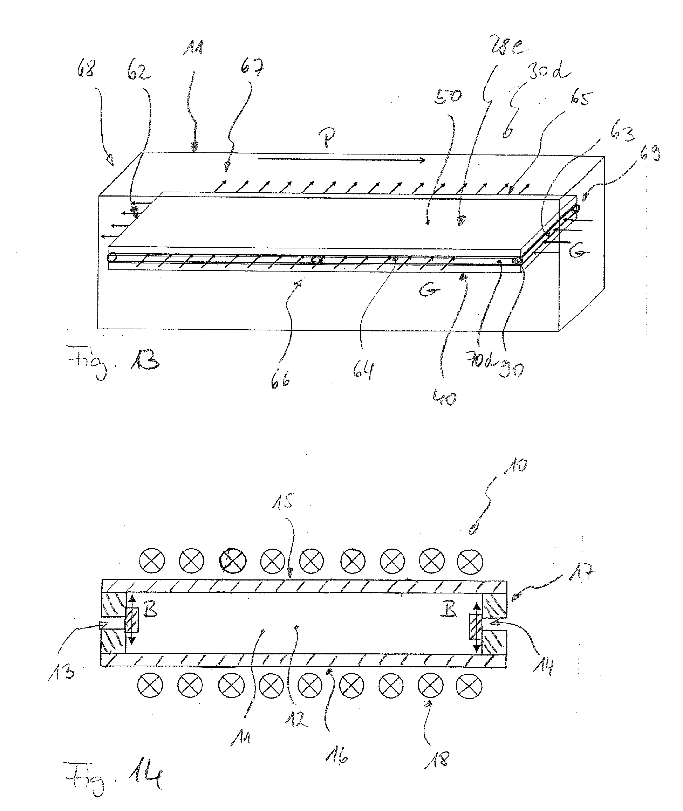

Mit Fig. 1 ist der prinzipielle Aufbau der erfindungsgemäßen Anordnung mit zwei zu prozessierenden Mehrschichtkörpern bzw. Substraten 40, 50 gezeigt, wie sie in eine Anlage zum Prozessieren integrierbar ist. Fig. 14 zeigt eine derartige Anlage in einer Seitenansicht 10.

Die Anlage 10 ist ausgelegt, großflächige Substrate zu prozessieren. Zu erkennen ist (s. Fig. 14), dass die Anlage eine Prozesskammer 11 mit einem Kammerdeckel 15, einem Kammerboden 16, Kammerwänden 17 (und damit mit einem Kammerraum 12), eine Eingangstür 13 und eine der Eingangstür gegenüberliegende Ausgangstür 14 aufweist. Die Prozesskammer 11 oder Behandlungskammer weist hier z. B. einen Tunnel auf bzw. bildet einen Tunnel aus, der beispielsweise mit den Türen (Schleusen) abdichtbar ist. Die Pfeile B deuten die Bewegungsrichtung der Eingangstür bzw. der Ausgangstür an.

Zum Transport der mindestens beiden Mehrschichtkörper bzw. der Mehrschichtkörperanordnung (hier nicht gezeigt) ist eine Transportvorrichtung (nicht gezeigt) vorgesehen, die die Substrate durch die Türen bzw. Schleusen 13, 14 durch die Prozesskammer 11 transportieren kann. Auch das manuelle Einbringen ist möglich. Ober- und unterhalb der Prozesskammer 11 sind mehrere punktförmige Quellen 18 für elektromagnetische Strahlung z. B. matrixartig angeordnet. Auch eine andere Art von Quellen und/oder einen andere Anordnung dieser Quellen ist möglich. Zum Durchlass der Strahlung sind der Kammerdeckel 15 und der Kammerboden 16 der Prozesskammer 11 zumindest bereichsweise zumindest teiltransparent ausgebildet, um eine homogene Energieeinwirkung auf die Substrate zu ermöglichen.

Die Energiequellen können auch innerhalb der Kammer 11 angeordnet sein, dann kann die Wandung der Prozesskammer auch nicht-transparent ausgebildet sein. Auch ist es möglich, die Energiequellen in den entsprechenden Wänden oder Wandabschnitten der Kammer anzuordnen und/oder die Wände derart auszubilden, dass diese unter Einwirkung von Energiequellen als Sekundärstrahler dienen.

Zurück zur erfindungsgemäßen Vorrichtung bzw. Anordnung. Die Mehrschichtkörper 40, 50 sind derart zueinander angeordnet, dass sich die beschichteten und zu prozessierenden Oberflächen 44, 54 gegenüberliegen (Head-to-Head- bzw. Face-to-Face-Anordnung, Head-to-Head-RTP). Die Substrate 40, 50 liegen dabei im Gebrauch horizontal und sind sandwichförmig übereinander angeordnet. Insofern kann von einem unteren Mehrschichtkörper 40 bzw. einem unteren Substrat und einem oberen Mehrschichtkörper 50 bzw. einem oberen Substrat gesprochen werden. Es ist anzumerken, dass die Mehrschichtkörperanordnung hier "frei schwebend" gezeichnet ist. Dies soll lediglich den Prinzipaufbau der mindestens zwei Substrate aufzeigen, so wie sie in der Anlage prozessiert werden. Deren Lagerungsmöglichkeiten werden nachfolgend detailliert beschrieben.

Mit einer derartigen Anordnung der Substrate 40, 50 lässt sich ein definierter Raum zwischen den zu prozessierenden Oberflächen 44, 45 ausbilden. Zudem werden die beiden Substrate 40, 50 gleichzeitig prozessiert, also z. B. selenisiert, so dass sich der Durchsatz durch die Anlage (z. B. wie mit Fig. 14 gezeigt) deutlich erhöht. Der definierte Raum zwischen den Substraten, der sogenannte Prozessraum 21', kann so z. B. gezielt mit einer bestimmten Menge eines Prozessgases für die Durchführung der Prozessierung befüllt werden. Das heißt, in dem Prozessraum 21' erfolgt letztendlich im Wesentlichen die Prozessierung.

In der oben beschriebenen Anlage 10 ist es oftmals erwünscht, den Kammerraum 12 der Prozesskammer 11 zu verringern, um die Prozessgaszufuhr bzw. auch - abfuhr und auch die Prozessgasmenge besser kontrollieren zu können. In einem definierten Raum ist auch die Prozessierung, also z. B. die Umwandlung der beschichteten Substratoberflächen besser kalkulier- und nachvollziehbar. Insofern ist der definierte Prozessraum zweckmäßig.

Oftmals ist in bekannten Kammerräumen einer Prozesskammer eine Einrichtung zur Ausbildung eines reduzierten Kammerraums (und damit zur Ausbildung des bereits beschriebenen Prozessraums) anordenbar oder angeordnet. Solche Einrichtungen sind z. B. als sogenannte Prozessboxen innerhalb der Prozesskammer vorgesehen, in welche die zu prozessierenden Substrate aufgenommen werden. Auch sind Prozesshauben bekannt, die über die zu prozessierenden Substrate gestülpt (auf die Substrate abgesenkt) werden und auf dem unteren Substrat, auf dem Kammerboden oder einer expliziten Auflage aufliegen.

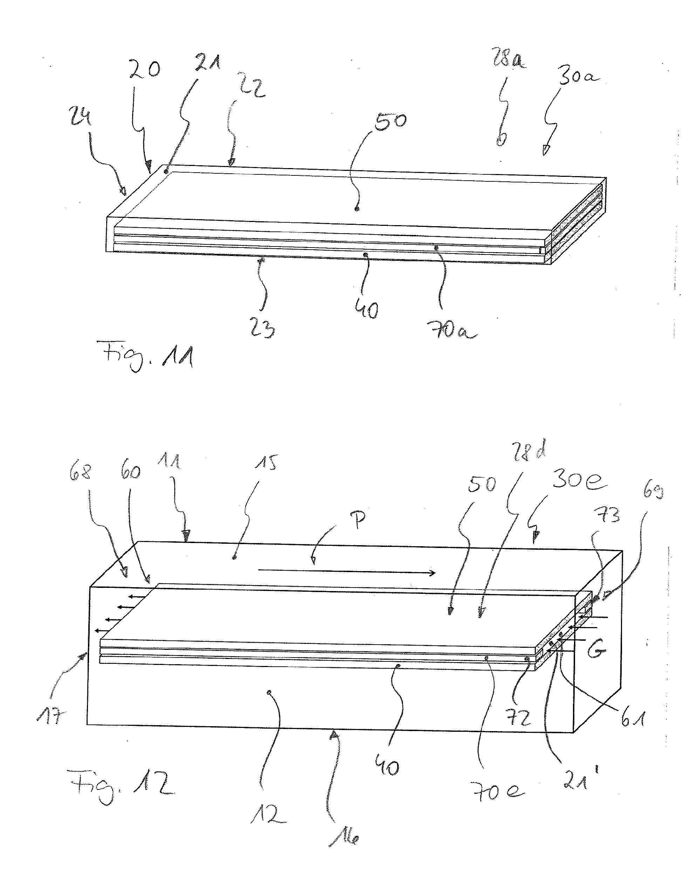

Mit der erfindungsgemäßen Vorrichtung bzw. Anordnung ist es nun möglich, bereits einen definierten Prozessraum 21' vorzusehen, da sich die Substrate 40, 50 gegenüberliegen. Dennoch können zusätzlich, je nach Anforderung an die Prozessierung, explizite Prozessboxen 20, -hauben oder dergleichen Einrichtungen zum Ausbilden eines reduzierten Kammerraums eingesetzt werden (s. z. B. Fig. 11). Sind keine Einrichtungen 20 zum Ausbilden eines reduzierten Kammerraums vorgesehen, bilden auch die Substrate 40, 50 mindestens teilweise diese Einrichtung, also z. B. die Prozessbox, aus.

Der Pfeil P deutet die Richtung der Prozessführung an, d. h., die Richtung, in der die Mehrschichtkörperanordnung in der Anlage zum Prozessieren geführt wird.

Fig. 2 zeigt eine Ausführungsform einer erfindungsgemäßen Vorrichtung 30a zum Positionieren bzw. eine Mehrschichtkörperanordnung 28a. Um die Substrate 40, 50 (gemäß Fig. 1) zu positionieren, zu der Mehrschichtkörperanordnung zusammenzufügen und in der entsprechenden Anlage zu prozessieren, umfasst die Vorrichtung 30a zum Positionieren hier mindestens ein (erstes) Beabstandungselement oder auch Auflageelement 70a. Das Beabstandungselement 70a ist zwischen den Substraten 40, 50 angeordnet und beabstandet diese voneinander. Hierbei liegt das obere Substrat 50 auf dem Beabstandungselement 70a auf, während das untere Substrat 40 an dem Beabstandungselement 70a anliegt. Die so positionierten Substrate bilden die Mehrschichtkörperanordnung 28a aus.

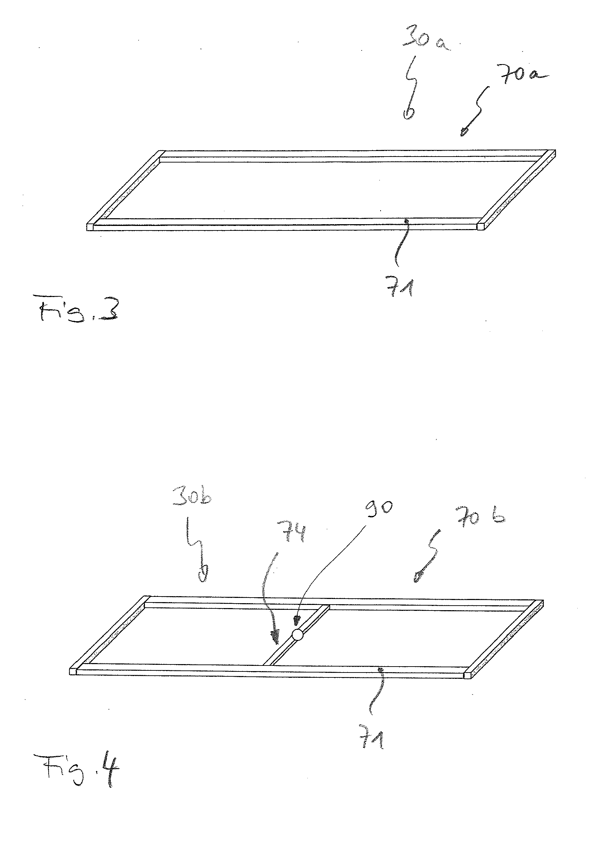

Fig. 3 zeigt das Beabstandungselement 70a alleine. Wie erkennbar, weist das Beabstandungselement 70a ein Rahmenelement 71 auf (bzw. ist als solches ausgebildet). In diesem Falle bildet der Rahmen 71 die Konturen der Substrate (nicht gezeigt) nach (hier rechteckförmig), so dass diese auf dem Rahmenelement 71 mit ihren Kanten bzw. Kantenbereichen 41, 51 aufliegen bzw. an diesem anliegen. Zur Lagerung des unteren Substrats 40 sind weitere Maßnahmen zu treffen, die nachfolgend noch beschrieben werden.

Fig. 4 zeigt eine weitere Ausgestaltung einer Vorrichtung 30b zum Positionieren, hier eines Beabstandungselements 70b. Das Beabstandungselement 70b, hier wieder ein Rahmenelement 71, weist ein Querverbindungselement 74 zum Verbinden von gegenüberliegenden Bereichen des Rahmenelements 71 auf. Damit lässt sich ein Durchbiegen eines aufliegenden Substrats vermeiden.

Um nun aber die zu prozessierenden Oberflächen 44, 54 nicht zu sehr abzudecken, weist das Querverbindungselement 74 mindestens ein Abstützelement 90 auf, auf das oder an das das Substrat bzw. die Substrate (nicht gezeigt) auflegbar oder anlegbar ist bzw. sind. In diesem Falle ist das Abstützelement 90 derart ausgebildet, dass es dieselbe Höhe aufweist, wie das übrige Rahmenelement 71. Nur so ist eine ebene Auflagefläche für die Substrate 40, 50 gewährleistet. Sowohl das Rahmenelement 71, als auch das Querverbindungselement 74 können ein oder auch mehrere Abstützelemente aufweisen. Die Auflagebereiche reduzieren sich dadurch, so dass die Substrate an den zu prozessierenden Oberflächen 44, 54 möglichst frei liegen.

Die Anzahl der Querverbindungselemente und der Abstützelemente ist beliebig und je nach Bedarf variierbar. Auch die Anordnung der Abstützelemente ist variierbar, d. h. die Abstützelemente können an den Rahmenelementen und/oder an den Querverbindungselementen angeordnet sein. Die Abstützelemente 90 sind vorzugsweise, so wie in Fig. 4 erkennbar, als Punktstützenelemente ausgebildet, also z. B. kugelförmig. Mit den Kugelelementen sind nur kleine Auflagebereiche vorgesehen. Auch nadelförmig ausgebildete Abstützelemente sind denkbar.

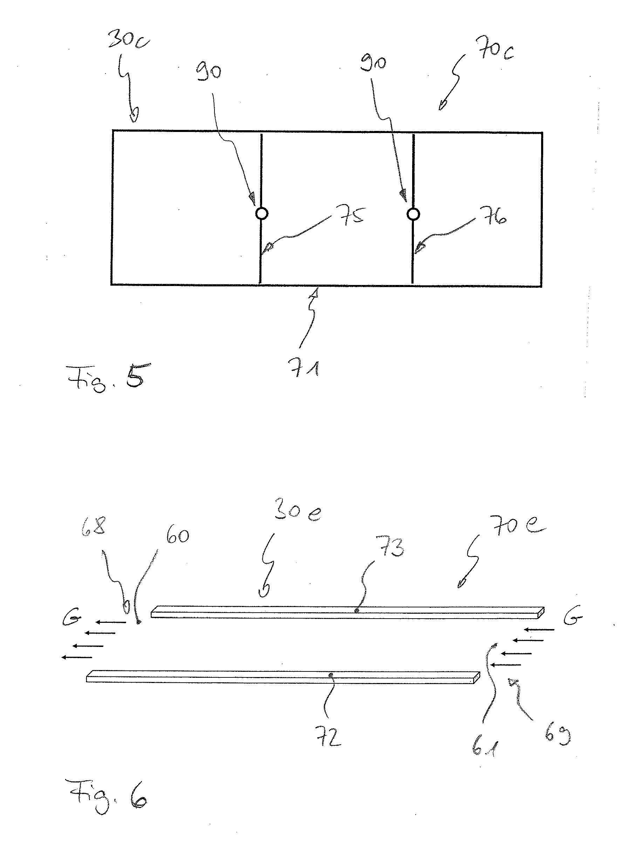

Fig. 5 zeigt eine weitere Ausgestaltung einer Vorrichtung 30c zum Positionieren, hier eines Beabstandungselements 70c (Rahmenelement 71), hier mit zwei Querverbindungselementen 75, 76, an denen jeweils ein Punktstützenelement 90 angeordnet ist.

Auch Fig. 6 zeigt eine weitere Ausgestaltung einer Vorrichtung 30e zum Positionieren, hier eines Beabstandungselements 70e. Das Beabstandungselement 70e weist in einer Erstreckungsebene der Substrate (nicht gezeigt) sich im Gebrauch gegenüberliegende Rahmenleistenelemente 72, 73 auf, so dass die Substrate an deren Kantenbereichen, z. B. an deren Längsseiten, mindestens teilweise auf die Rahmenleistenelemente 72, 73 auflegbar oder an die Rahmenleistenelemente anlegbar sind. An den Querseiten 68, 69 wird aufgrund der Ausgestaltung der Rahmenleistenelemente jeweils mindestens ein Öffnungsbereich 60, 61 an der Mehrschichtkörperanordnung (hier angedeutet) vorgesehen (s. z. B. Fig. 12). Möglich ist es natürlich auch, die Öffnungsbereiche an den Längsseiten vorzusehen.

Die Pfeile G deuten die Strömungsrichtung des Prozessgases an. Hierzu wird nachfolgend noch Näheres beschrieben.

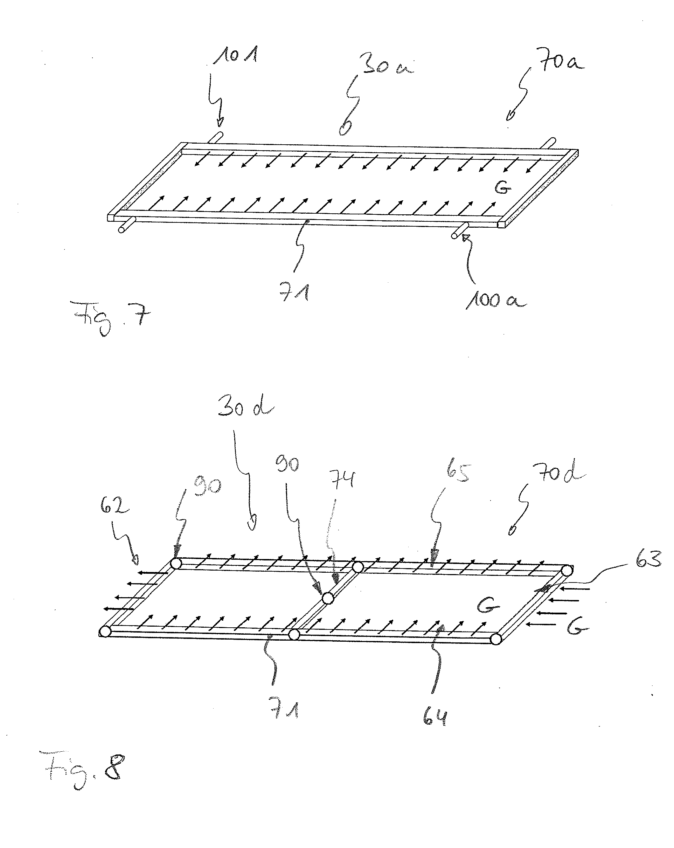

Fig. 7 zeigt schließlich nochmals das Beabstandungselement 70a (s. Fig. 3), allerdings sind hier Vorrichtungen (bzw. eine Vorrichtung) 100a zum Zu- und/oder Abführen von Prozessgas vorgesehen. Auch hier deuten die Pfeile G eine mögliche Strömungsrichtung des Prozessgases an.

Wie bereits oben beschrieben, wird die Prozessierung der beschichteten Substratfläche bzw. der Substratbeschichtung unter Prozessgasatmosphäre durchgeführt, um so z. B. den gewünschten Chalkopyrit-Halbleiter zu erhalten. Als Prozessgase können z. B. H₂, N₂, Ar, H₂S, H₂Se, S-Gas und/oder Se-Gas vorgesehen werden, d. h. also ggf. - je nach Prozessart - auch gasförmiges Selen und/oder gasförmiger Schwefel. Grundsätzlich wäre eine Prozessierung auch ohne Prozessgas möglich, beispielsweise in einer vollständig geschlossenen Prozessbox. In diesem Falle könnten die Substrate auch direkt aufeinander liegen und so einen minimierten Prozessraum ausbilden.

Das Prozessgas muss derart in den Kammerraum und insbesondere in den Prozessraum zugeführt bzw. auch wieder aus diesem abgeführt werden, dass optimale Prozessierungsbedingungen herrschen.

Da gerade mit der vorliegenden Vorrichtung (zwei Substrate, deren Precursor-Schichten gegenüberliegend angeordent sind) bereits ein bestimmter Prozessraum ausgebildet wird, kann das Prozessgas beispielsweise über das Beabstandungselement zugeführt werden (von einer Gasquelle), ggf. sogar unter Umgehung des Kammerraums und/oder des Prozessraums einer expliziten Prozessbox.

Das Beabstandungselement 70a gemäß Fig. 7 weist also ein Gaszufuhrelement und/oder ein Gasabfuhrelement 100a zum Zuführen und/oder Abführen des Prozessgases in den und/oder aus dem Prozessraum auf. Bei dieser Art Beabstandungselement 70a wird ein quasi-geschlossener Prozessraum gebildet, da das Rahmenelement den Raum zwischen den Precursor-Schichten im Wesentlichen vollständig abschließt. Eine fluiddurchlässige, insbesondere gasdurchlässige Verbindung zwischen dem Kammerraum der Anlage und dem Prozessraum oder auch nur zwischen der Gasquelle und dem Prozessraum zwischen den beiden Substraten wird so über die Gaszufuhrelemente und/oder ein Gasabfuhrelemente gewährleistet.

Das Gaszufuhrelement bzw. Gasabfuhrelement 100a kann beispielsweise als ein in das Beabstandungselement integrierter Gasverteiler-Kamm mit mindestens einem Anschlusselement 101 zum Anschließen einer Gaszuführleitung und/oder Gasabführleitung (nicht gezeigt) ausgebildet sein. Der gezeigte Rahmen 70a weist z. B. vier Anschlusselemente 101 auf (zum Anschluss von Gasleitungen), so dass das Gas über das hohle Rahmenelement und entsprechende Öffnungen (nicht sichtbar) für den Gasauslass (oder -einlass) in den Prozessraum, also zwischen die Substrate eindringen kann (partieller bzw. anpassbarer Gasaustausch zwischen Ofenumgebung (Umgebung in der Kammer oder im Tunnel oder auch Umgebung in einer expliziten Prozessbox oder Prozesshaube) und Precursor-Dünnschichten oder direkt zwischen Gasquelle und Precursor-Dünnschichten).

An sich können die Gasverteiler 100a auch anderweitig an der Kammer angeordnet werden. Wichtig ist es, ein homogenes Einleiten des Prozessgases zu ermöglichen, so dass es zu einer möglichst laminaren Gasströmung über die Substratoberfläche von z. B. einer Längskante zur anderen kommt. Die Gaszufuhr kann an vorgegebenen Einlässen der Gasverteiler zu beliebigen Zeiten des Temperprofiles gesteuert werden. Verbrauchte Mengen des Prozessgases können so nachgeladen werden und/oder nicht mehr erwünschter überschüssiger Selendampf (oder sonstige Komponenten des Dampfes) kann aus der Reaktionskammer zum richtigen Zeitpunkt verdrängt werden.

Fig. 8 zeigt eine weitere Ausgestaltung einer Vorrichtung 30d zum Positionieren, hier eines Beabstandungselements 70d. Dieses umfasst ein Rahmenelement 71 mit einem Querverbindungselement 74 und mehreren Abstützelementen 90 (jeweils ein Abstützelement an den Ecken des Rahmenelements und an den Schnittpunkten von Rahmenelement und Querverbindungselement sowie ein Abstützelement an dem Querverbindungselement). Die Abstützelemente 90 sind hier wiederum als Kugelelemente ausgebildet.

In diesem Falle sind die Kugelelemente 90 in ihrem Durchmesser größer als die Höhe des Rahmenelements 71 ausgebildet. Insofern sind die auf- oder anliegenden Substrate (nicht gezeigt) nur auf den Kugelelementen 90 lagerbar, so dass Öffnungsbereiche 62, 63, 64, 65 an der Mehrschichtkörperanordnung (hier angedeutet) zum Gasaustausch zwischen dem Rahmenelement 71 und den Substraten verbleiben. Auch auf diese Art lässt sich ein quasi-offener Prozessraum, d. h., eine quasi-offene Sandwich-Vorrrichtung ausbilden. Zur besseren Übersicht sind nur zwei der Kugelelemente mit dem Bezugszeichen 90 versehen. Nachfolgend werden weitere verschiedene Ausführungsformen der erfindungsgemäßen Vorrichtung bzw. Anordnung (Mehrschichtkörperanordnung) dargestellt, die einige der soeben beschriebenen Beabstandungselemente zeigen.

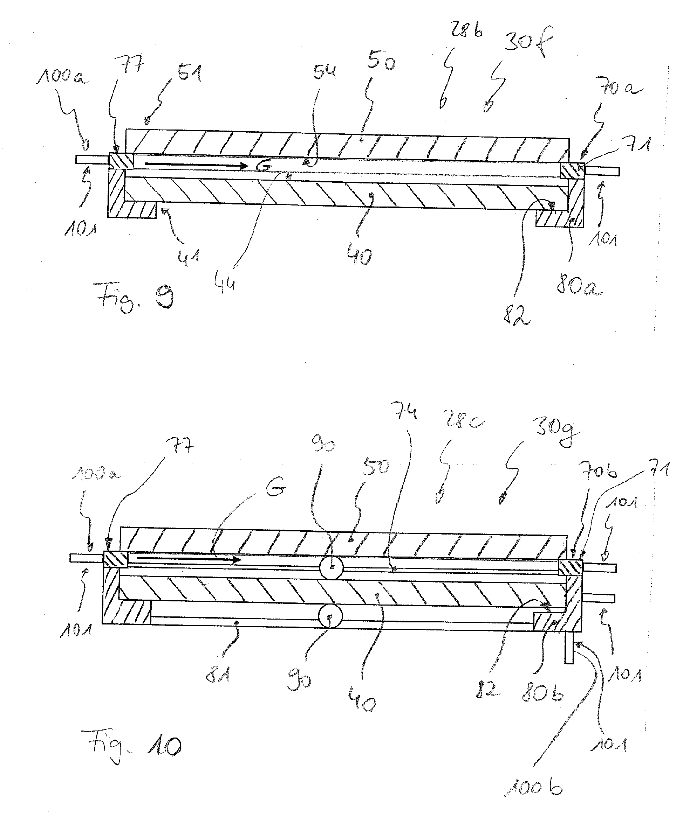

Fig. 9 zeigt eine weitere Ausgestaltung einer erfindungsgemäßen Vorrichtung 30f zum Positionieren bzw. einer erfindungsgemäßen Mehrschichtkörperanordnung 28b in einer Schnittdarstellung. Das erste Beabstandungselement 70a (s. z. B. Fig. 3 oder 7) umfasst hier zusätzlich eine Vorrichtung 100a zum Zu- und Abführen von Prozessgas, da der Rahmen 71 selbst den Prozessraum abschließt. Ferner ist ein zweites Beabstandungselement 80a vorgesehen. Das zweite Beabstandungselement 80a ist hier zur Aufnahme des unteren Mehrschichtkörpers 40 vorgesehen und ist mindestens teilweise unter dem unteren Mehrschichtkörper 40 anordenbar bzw. angeordnet. Außerdem ist es zur Aufnahme des ersten Beabstandungselements 70a ausgebildet, so dass das zweite Beabstandungselement 80a, der untere Mehrschichtkörper 40, das erste Beabstandungselement 70a und der obere Mehrschichtkörper 50 sandwichförmig als Mehrschichtkörperanordnung 28b anordenbar sind bzw. hier angeordnet sind.

Beide Beabstandungselemente 70a, 80a weisen Auflagebereiche 77, 82 auf, über welche die Substrate 40, 50 auf- oder anlegbar sind.

Das zweite Beabstandungselement 80a kann selbst als Rahmenelement ausgebildet sein oder beispielsweise auch zwei Rahmenleistenelemente vorsehen. Die mit den Figuren 2 bis 8 gezeigten Ausgestaltungen der Beabstandungselemente können ebenfalls für das zweite Beabstandungselement vorgesehen sein.

Wie aus der Figur ersichtlich, könnte das zweite, also untere Beabstandungselement 80a auch derart ausgebildet sein, dass es mit dem unteren Auflagebereich 82 das untere Substrat 40 aufnimmt und in einem oberen Auflagebereich das obere Substrat 50. Gegebenenfalls müsste das untere Substrat dann auf den unteren Auflagebereich seitlich eingeschoben werden. Eine Lagerung mit dem zweiten Beabstandungselement alleine ist also ebenfalls möglich.

In dem in Fig. 9 gezeigten Ausführungsbeispiel ist das erste Beabstandungselement 70a auf das zweite Beabstandungselement 80a aufgesetzt, so dass letztendlich mit den Substraten 40, 50 die sandwichförmige Anordnung ausgebildet wird.

Die Gaszufuhr- und/oder -abfuhrelemente können nur an einem oder auch an beiden Beabstandungselementen vorgesehen sein. Der Pfeil G deutet die Richtung der Gasströmung an.

Fig. 10 zeigt im Wesentlichen die bereits mit Fig. 9 beschriebene Ausführungsform der erfindungsgemäßen Vorrichtung bzw. Anordnung. Allerdings sind die Beabstandungselemente (Rahmenelemente) mit den Querverbindungselementen ausgebildet und zudem mit Punktstützenelementen, die hier nur an den Querverbindungselementen vorgesehen sind. Das heißt, es ist eine Vorrichtung 30g zum Positionieren gezeigt bzw. eine Mehrschichtkörperanordnung 28c Das erste Beabstandungselement 70b (Rahmenelement 71 mit Querverbindungselement 74) ist z. B. dasjenige aus Fig. 4, jedoch mit einer Vorrichtung 100a zum Zu- und/oder Abführen von Prozessgas. Ein zweites Beabstandungselement 80b entspricht im Wesentlichen demjenigen in Fig. 9, allerdings mit einer weiteren Vorrichtung 100b zum Zu- und/oder Abführen von Prozessgas. Das Beabstandungselement 70b weist z. B. das Querverbindungselement 74 auf, das Beabstandungselement 80b ein Querverbindungselement 81. Mittig an den Querverbindungselementen ist jeweils ein Abstützelement 90 angeordnet. Die Substrate liegen so jeweils auf den Auflageflächen bzw. Auflagebereichen 77 bzw. 82 und den jeweiligen Abstützelementen 90 auf. Auch hier deutet der Pfeil G die Richtung der Gasströmung an.

Fig. 11 zeigt die erfindungsgemäße Vorrichtung 30a bzw. Anordnung 28a, wie sie z. B. mit Fig. 2 beschrieben ist. Auch diese Darstellung ist eine prinzipielle, da die Möglichkeit des Gasaustausches mit der Umgebung nicht explizit dargestellt ist (Austausch z. B. zwischen Prozessraum zwischen den Substraten und Prozessraum der Box sowie zwischen Box und Kammerraum oder auch lediglich zwischen Gasquelle und Prozessraum zwischen den Substraten). Mit dieser Abbildung soll die Anordnung der erfindungsgemäßen Anordnung 28a bzw. Vorrichtung 30a in einer Einrichtung 20 zur Ausbildung eines reduzierten Kammerraumes, hier einer Prozessbox, aufgezeigt werden. Die Einrichtung 20 ist dann zusammen mit der Mehrschichtkörperanordnung 28a in die Anlage 10 (s. Fig. 14) zum Prozessieren einbringbar, so dass die gewünschten Prozesse durchgeführt werden können. Grundsätzlich ist auch an eine Prozessierung ohne jeglichen Gasaustausch (z. B. zwischen Prozesskammer und Prozessbox bzw. zwischen einer Gasquelle und der Prozesskammer bzw. Prozessbox oder -haube) zu denken.

Fluid- insbesondere Gasaustausch zwischen den Ebenen der Prozessieranlage ist auf unterschiedliche Weise möglich. So kann z. B. der Austausch von Gas zwischen einer (z. B. externen) Gasquelle, der Prozesskammer (oder dem Prozesstunnel) und ggf. der Prozessbox oder -haube erfolgen. Auch kann der Gasaustausch zwischen externer Gasquelle und einer ggf. vorhandenen Prozessbox oder -haube unter Umgehung der Prozesskammer erfolgen, d. h., die Prozessbox steht mit der Gasquelle unmittelbar in Verbindung. Möglich ist es auch, den Gasaustausch lediglich zwischen der durch die Substrate ausgebildeten Prozessbox und der Gasquelle zu gewährleisten.

Die beiden Substrate 40, 50 sind mit dem dazwischen angeordneten Beabstandungselement 70a in der Prozessbox 20 gelagert. Die Prozessbox 20 umfasst ein Bodenelement 23, ein Deckelelement 22 und Seitenwandelemente 24 und umschließt so die Anordnung. Somit sind neben dem Kammerraum 12 der Prozesskammer (nicht gezeigt) ein expliziter Prozessraum 21 vorgesehen und die Prozessierung läuft in einem definierten Raumvolumen ab. Dies erleichtert die Zuführung einer definierten Prozessgasmenge.

Das untere Substrat 40 liegt auf dem Bodenelement 23 der Prozessbox 20 auf, so dass auf ein zweites Beabstandungselement (einem unteren Beabstandungselement) verzichtet werden kann. An dieser Anordnung lassen sich nun, wie gewünscht, entsprechende Gaszufuhr- und/oder -abfuhrelemente (nicht gezeigt, aber wie z. B. oben beschrieben) anbringen.

Fig. 12 zeigt die erfindungsgemäße Vorrichtung 30e von Fig. 6 bzw. eine Anordnung 28d der zwei Mehrschichtkörper 40, 50 mit dem dazwischen angeordneten Beabstandungselement 70e im Kammerraum 12 einer Prozesskammer 11 oder in einem Tunnel einer Anlage. Hier ist keine explizite Prozessbox vorgesehen, vielmehr wird ein Prozessraum 21' durch die Anordnung selbst ausgebildet. Das heißt, die Substrate 40, 50 und auch die Vorrichtung zum Positionieren, hier das Beabstandungselement 70e, bilden mit die Prozessbox aus, so dass der zwischen den Precursor-Schichten bzw. den zu prozessierenden Oberflächen vorgesehene Raum im Wesentlichen als der Prozessraum 21' ausgebildet ist.

Das Beabstandungselement 70e entspricht den in Fig. 6 beschriebenen beiden gegenüberliegenden Rahmenleistenelementen, so dass an der Anordnung 28d an den Querseiten 68, 69 jeweils ein Öffnungbereich 60, 61 ausgebildet ist. Über diese Öffnungsbereiche 60, 61 findet der Gasaustausch mit dem Kammerraum bzw. Tunnelraum statt. Somit ist im Prinzip ein quasi-offener Prozessraum 21' mit einem quasi-offenen Beabstandungselement 70e ausgebildet.

Die Prozessführung ist wie mit dem Pfeil P angedeutet vorgesehen, d. h., die Prozessbox mit der Beladung wird in die mit dem Pfeil angedeutete Richtung in die Gesamtanlage transportiert. Üblicherweise sind hierfür die Schleusen 13, 14 an der Prozesskammer 11 vorgesehen, so dass im Kammerraum 12 ein entsprechender Prozessgasdruck einstellbar ist. Die entgegengesetzt gerichteten kurzen Pfeile G zeigen auf, wie das Prozessgas durch den Prozessraum (zwischen den beiden Substraten geführt) wird. Mit dem quasi-offenen Beabstandungselement kann auf explizite Gaszufuhrelemente bzw. Gasabfuhrelemente verzichtet werden. Das Gas wird von mindestens einer Gasquelle aus eingeleitet, beispielsweise von der oben bereits erwähnten externen Gasquelle, um Kammerraum 12 und Prozessraum 21' zu befüllen.

Die Anordnung 28d ist hier rein schematisch frei schwebend abgebildet. In der Praxis müssten zu deren Lagerung explizite Elemente, wie z. B. ein zweites Beabstandungselement, vorgesehen sein, das selbst auf dem Bodenbereich der Kammer oder des Tunnels aufliegt oder aber die Anordnung liegt auf dem Kammerboden 16 oder auf einem Carrier auf.

Fig. 13 zeigt eine Anordnung 28e bzw. die Vorrichtung 30d (Fig. 8), die ebenfalls in einem Kammerraum oder Tunnelraum 12, wie mit Fig. 12 beschrieben, angeordnet sind. Das Beabstandungselement 70d ist das mit Fig. 8 beschriebene. Da die Substrate 40, 50 nur auf den Kugelelementen aufliegen bzw. an diesen anliegen, ist die Anordnung eine quasi-offene, das Prozessgas kann, wie mit den kurzen Pfeilen angedeutet, zwischen der Kammer- bzw. Tunnelumgebung über die Öffnungsbereiche 62, 63 an den Querseiten 68, 69 bzw. über die Öffnungsbereiche 64, 65 an den Längsseiten 66, 67 der Anordnung 28d ausgetauscht werden.

Fig. 14 zeigt schließlich die bereits oben beschriebene Anlage 10, in die die Anordnungen 28a, 28b, 28c, 28d und/oder 28e mit den Vorrichtungen 30a, 30b, 30c, 30d, 30e, 30f und/oder 30g zum Positionieren (hier nicht eingezeichnet) zum Prozessieren mit oder ohne explizite Einrichtung zum Ausbilden eines reduzierten Kammerraums eingebracht werden können.

Der Transport der Anordnung bzw. der Vorrichtung (mit oder ohne Einrichtung zum Ausbilden eines reduzierten Kammerraums) in die Anlage und aus dieser heraus erfolgt beispielsweise über eine Transportvorrichtung (nicht gezeigt), die mit oder ohne Träger (also z. B. Carrier) für die Substrate arbeitet oder auch manuell. Auch der Zusammenbau der Mehrschichtkörperanordnung in der Anlage ist möglich.

Die Mehrschichtkörperanordnung könnte ebenfalls auf einem Carrier aufgebaut werden und so in die Prozesskammer oder in einen Prozesstunnel der Prozessieranlage (z. B. mittels einer Transportvorrichtung) eingebracht werden (in der sich z. B. eine Prozesshaube befindet, die auf die Mehrschichtkörperanordnung absenkbar ist). Auch ohne eine explizite Einrichtung zur Ausbildung eines reduzierten Kammerraums ließe sich die Prozessierung durchführen.

Mit der vorgestellten Vorrichtung zum Positionieren von Gegenständen, mit einer damit ausgebildeten Mehrschichtkörperanordnung, mit einer Mehrschichtkörperanordnung, die ohne Vorrichtung zum Positionieren zusammengebaut ist, einer Anlage zum Prozessieren der Mehrschichtkörperanordnung und mit den entsprechenden Verfahren zum Ausbilden der Mehrschichtkörperanordnung lassen sich Mehrschichtkörper, z. B. Substrate, auf einfache Weise mit hohem Durchsatz prozessieren (beispielsweise zur Herstellung von Chalkopyrit-Halbleitern).

### Bezugszeichenliste

- 10: Anlage zum Prozessieren
- 11: Prozesskammer, -tunnel
- 12: Kammerraum
- 13: Eingangstür
- 14: Ausgangstür
- 15: Kammerdeckel
- 16: Kammerboden
- 17: Kammerwand bzw. -wände
- 18: Quelle(n) für elektromagnetische Strahlung
- 20: Einrichtung zur Ausbildung eines reduzierten Kammerraums, Prozessbox
- 21, 21': Prozessraum
- 22: Deckelelement
- 23: Bodenelement
- 24: Seitenwandelement(e)
- 28a: Anordnung, Mehrschichtkörperanordnung
- 28b: Anordnung, Mehrschichtkörperanordnung
- 28c: Anordnung, Mehrschichtkörperanordnung
- 28d: Anordnung, Mehrschichtkörperanordnung
- 28e: Anordnung, Mehrschichtkörperanordnung
- 30a: Vorrichtung zum Positionieren
- 30b: Vorrichtung zum Positionieren
- 30c: Vorrichtung zum Positionieren
- 30d: Vorrichtung zum Positionieren
- 30e: Vorrichtung zum Positionieren
- 30f: Vorrichtung zum Positionieren
- 30g: Vorrichtung zum Positionieren
- 40: Unterer Mehrschichtkörper, Substrat
- 41: Kantenbereich(e)
- 44: Zu prozessierende Oberfläche
- 45: (Precursor-) Beschichtung
- 50: Oberer Mehrschichtkörper, Substrat
- 51: Kantenbereich(e)
- 54: Zu prozessierende Oberfläche
- 55: (Precursor-) Beschichtung
- 60: Öffnungsbereich Anordnung
- 61: Öffnungsbereich Anordnung
- 62: Öffnungsbereich Anordnung
- 63: Öffnungsbereich Anordnung
- 64: Öffnungsbereich Anordnung
- 65: Öffnungsbereich Anordnung

- 66: Längsseite Anordnung
- 67: Längsseite Anordnung
- 68: Querseite Anordnung
- 69: Querseite Anordnung
- 70a: Erstes Beabstandungselement
- 70b: Erstes Beabstandungselement
- 70c: Erstes Beabstandungselement
- 70d: Erstes Beabstandungselement
- 70e: Erstes Beabstandungselement
- 71: Rahmenelement
- 72: Rahmenleistenelement
- 73: Rahmenleistenelement
- 74: Querverbindungselement
- 75: Querverbindungselement
- 76: Querverbindungselement
- 77: Auflagebereich
- 80a: Zweites Beabstandungselement
- 80b: Zweites Beabstandungselement
- 81: Querverbindungselement
- 82: Auflagebereich
- 90: Abstützelement(e)
- 100a: Vorrichtung zum Zu- und/oder Abführen von Prozessgas, Gaszufuhrelement(e) und/oder Gasabfuhrelement(e)
- 100b: Vorrichtung zum Zu- und/oder Abführen von Prozessgas, Gaszufuhrelement(e) und/oder Gasabfuhrelement(e)
- 101: Anschlusselement(e)
- G: Richtung Gasströmung
- P: Richtung Prozessführung
- B: Bewegungsrichtung Eingangstür, Ausgangstür

## Patentansprüche

1. Vorrichtung (30a, 30b, 30c, 30d, 30e, 30f, 30g) zum Positionieren von mindestens zwei Gegenständen, insbesondere von mindestens zwei Mehrschichtkörpern (40, 50) mit jeweils mindestens einer zu prozessierenden Oberfläche (44, 54),
wobei die Vorrichtung (30a bis 30g) zur Aufnahme der mindestens zwei Gegenstände, insbesondere Mehrschichtkörper (40, 50), derart ausgebildet ist, dass sich die jeweils zu prozessierenden Oberflächen (44, 54) gegenüberliegen und die Gegenstände, insbesondere Mehrschichtkörper (40, 50), so einen zwischen den Oberflächen (44, 54) angeordneten Prozessraum (21') ausbilden, in dem im Wesentlichen die Prozessierung erfolgt,
so dass die mindestens zwei Gegenstände als eine Mehrschichtkörperanordnung (28a, 28b, 28c, 28d, 28e) in einer Prozessieranlage (10) prozessierbar, insbesondere selenisierbar sind.

2. Vorrichtung nach Anspruch 1,
**dadurch gekennzeichnet, dass**
die Vorrichtung (30a bis 30g) derart ausgebildet ist, dass sie in einer Prozesskammer oder einem Prozesstunnel (11) der Prozessieranlage (10) mit einem Kammerraum (12) und/oder
in einer Einrichtung (20) zum Ausbilden eines reduzierten Kammerraums, vorzugsweise
- in einer Prozessbox (20) mit einem Bodenelement (23), einem Deckelelement (22) und vorzugsweise mit Seitenwandelementen (24) oder
- innerhalb einer Prozesshaube, die insbesondere zum stationären Verbleib
in der Prozessieranlage (10) ausgebildet ist,
und/oder
auf oder an einem Tragelement zum Transportieren der Mehrschichtkörperanordnung (28a bis 28e) mittels einer Transportvorrichtung in die Prozessieranlage (10) und aus dieser heraus,
anordenbar oder angeordnet ist.

3. Vorrichtung nach Anspruch 1 oder 2,
**dadurch gekennzeichnet, dass**
die Vorrichtung (30a bis 30g) derart ausgebildet ist, dass die Mehrschichtkörper (40, 50) im Gebrauch sandwichförmig übereinanderliegend angeordnet sind und so einen unteren Mehrschichtkörper (40) und einen oberen Mehrschichtkörper (50) der Mehrschichtkörperanordnung ausbilden.

4. Vorrichtung nach einem der vorhergehenden Ansprüche,
**dadurch gekennzeichnet, dass**
die Vorrichtung (30a bis 30g) derart ausgebildet ist und/oder in einem Kammerraum (12) einer Prozesskammer (11) der Prozessieranlage (10) anordenbar ist, dass die zwei Mehrschichtkörper (40, 50) derart anordenbar sind, dass sie mindestens teilweise die Einrichtung (20) zum Ausbilden eines reduzierten Kammerraums, vorzugsweise eine Prozessbox, ausbilden.

5. Vorrichtung nach einem der vorhergehenden Ansprüche,
**dadurch gekennzeichnet, dass**
die Vorrichtung (30a bis 30g) mindestens ein erstes Beabstandungselement (70a, 70b, 70c, 70d, 70e) aufweist, das zur Aufnahme des oberen Mehrschichtkörpers (50) und/oder des unteren Mehrschichtkörpers (40) ausgebildet ist,
wobei das Beabstandungselement (70a bis 70e) derart mindestens teilweise zwischen den zwei Mehrschichtkörpern (40, 50) anordenbar ist, dass diese beabstandet voneinander anordenbar oder angeordnet sind und so die Mehrschichtkörperanordnung (28a, 28b, 28c, 28d, 28e) ausbilden.

6. Vorrichtung nach einem der vorhergehenden Ansprüche,
**dadurch gekennzeichnet, dass**
die Vorrichtung (30a bis 30g) mindestens ein zweites Beabstandungselement (80a, 80b) aufweist,
das zur Aufnahme des oberen Mehrschichtkörpers (50) und/oder des unteren Mehrschichtkörpers (40) und zur Aufnahme des ersten Beabstandungselements (70a bis 70e) ausgebildet ist, derart, dass das zweite Beabstandungselement (80a, 80b), der untere Mehrschichtkörper (40), das erste Beabstandungselement (70a bis 70e) und der obere Mehrschichtkörper (50) sandwichförmig anordenbar oder angeordnet sind und so die Mehrschichtkörperanordnung (28b, 28c) ausbilden, wobei vorzugsweise das zweite Beabstandungselement (80a, 80b) im Gebrauch mindestens teilweise unter dem unteren Mehrschichtkörper (40) anordenbar oder angeordnet ist.

7. Vorrichtung nach einem der vorhergehenden Ansprüche,
**dadurch gekennzeichnet, dass**
das erste Beabstandungselement (70a bis 70e) und/oder das zweite Beabstandungselement (80a, 80b) jeweils mindestens ein Rahmenelement (71) und/oder ein Rahmenleistenelement (72, 73) aufweisen, so dass die Mehrschichtkörper (40, 50) vorzugsweise an deren Kantenbereichen (41, 51) mindestens teilweise auf das Rahmenelement und/oder das Rahmenleistenelement (71, 72, 73) auflegbar oder an das Rahmenelement und/oder das Rahmenleistenelement anlegbar sind.

8. Vorrichtung nach einem der vorhergehenden Ansprüche,
**dadurch gekennzeichnet, dass**
die zwei Mehrschichtkörper (40, 50) und das erste Beabstandungselement (70a bis 70e) oder
die zwei Mehrschichtkörper (40, 50) und das erste Beabstandungselement (70a bis 70e) und das zweite Beabstandungselement (80a, 80b) derart zueinander angeordnet sind, dass sie einen im Wesentlichen geschlossenen Prozessraum (21') ausbilden.

9. Vorrichtung nach einem der vorhergehenden Ansprüche, insbesondere nach Anspruch 7 oder 8,
**dadurch gekennzeichnet, dass**
das erste Beabstandungselement und/oder das zweite Beabstandungselement (80a, 80b) zwei Rahmenleistenelemente (72, 73) aufweisen, die sich im Gebrauch in einer Erstreckungsebene der Mehrschichtkörper (40, 50) gegenüberliegen, so dass die Mehrschichtkörper (40, 50) vorzugsweise an deren Kantenbereichen (41, 51), vorzugsweise an deren Längsseiten, mindestens teilweise auf die Rahmenleistenelemente (72, 73) auflegbar oder an die Rahmenleistenelemente anlegbar sind,
derart, dass an der Mehrschichtkörperanordnung (28a bis 28e), vorzugsweise jeweils an den Querseiten (68, 69), mindestens ein Öffnungsbereich (60, 61) zum Zuführen und/oder Abführen eines Prozessgases in den und/oder aus dem Prozessraum (21') ausgebildet ist.

10. Vorrichtung nach einem der vorhergehenden Ansprüche,
**dadurch gekennzeichnet, dass**
das erste Beabstandungselement (70a bis 70e) und/oder das zweite Beabstandungselement (80a, 80b) ein Gaszufuhrelement und/oder Gasabfuhrelement (100a, 100b) zum Zuführen und/oder Abführen des Prozessgases in den und/oder aus dem Prozessraum (21, 21') aufweisen, wobei vorzugsweise das Gaszufuhrelement und/oder Gasabfuhrelement (100a, 100b) als ein in das erste Beabstandungselement (70a bis 70e) und/oder das zweite Beabstandungselement (80a, 80b) integrierter Gasverteiler-Kamm mit mindestens einem Anschlusselement (101) zum Anschließen einer Gaszuführleitung und/oder Gasabführleitung ausgebildet ist.

11. Vorrichtung nach einem der vorhergehenden Ansprüche, insbesondere nach einem der Ansprüche 7 bis 10,
**dadurch gekennzeichnet, dass**
das erste Beabstandungselement (70a bis 70e) und/oder das zweite Beabstandungselement (80a, 80b) jeweils mindestens ein Querverbindungselement (74, 75, 76, 81) zum Verbinden von, in der Erstreckungsebene der Mehrschichtkörper (40, 50) sich gegenüberliegenden Bereichen des jeweiligen Rahmenelements (71) oder von sich im Gebrauch gegenüberliegenden Rahmenleistenelementen (72, 73) aufweisen, so dass der oder die Mehrschichtkörper (40, 50) zur Vermeidung einer Durchbiegung zusätzlich abstützbar ist oder sind.

12. Vorrichtung nach einem der vorhergehenden Ansprüche, insbesondere nach Anspruch 11,
**dadurch gekennzeichnet, dass**
das Querverbindungselement (74, 75, 76, 81) mindestens ein Abstützelement (90) aufweist, vorzugsweise ein Punktstützenelement, insbesondere vorzugsweise ein Kugelelement,
so dass die Mehrschichtkörper (40, 50) auf dem oder an dem Querverbindungselement (74, 75, 76, 81) über das Abstützelement (90) auflegbar oder anlegbar sind,
wobei das Abstützelement (90) derart ausgebildet ist, dass es dieselbe Höhe wie das jeweilige mindestens eine Rahmenelement oder Rahmenleistenelement (71, 72, 73) aufweist.

13. Vorrichtung nach einem der vorhergehenden Ansprüche, insbesondere nach einem der Ansprüche 7 bis 12,
**dadurch gekennzeichnet, dass**
das mindestens eine Rahmenelement oder Rahmenleistenelement (71, 72, 73) mindestens zwei Abstützelemente (90) derart aufweist, dass die Mehrschichtkörper (40, 50) auf den oder an den Abstützelementen (90) auflegbar oder anlegbar sind,
derart, dass an den Querseiten (68, 69) und/oder Längsseiten (66, 67) der Mehrschichtkörperanordnung (40, 50) jeweils mindestens ein Öffnungsbereich (60, 61, 62, 63, 64, 65) zum Zuführen und/oder Abführen des Prozessgases in den und/oder aus dem Prozessraum (21') ausgebildet ist.

14. Mehrschichtkörperanordnung (28a bis 28e), umfassend
- mindestens zwei Mehrschichtkörper (40, 50), mit jeweils mindestens einer zu prozessierenden Oberfläche (44, 54),
- mindestens eine Vorrichtung (30a bis 30g) zum Positionieren der mindestens zwei Mehrschichtkörper (40, 50) nach einem der Ansprüche 1 bis 13.

15. Mehrschichtkörperanordnung (28a bis 28e), umfassend mindestens zwei Mehrschichtkörper (40, 50), mit jeweils mindestens einer zu prozessierenden Oberfläche (44, 54),
wobei die mindestens zwei Mehrschichtkörper (40, 50) derart angeordnet sind, dass sich die jeweils zu prozessierenden Oberflächen (44, 54) gegenüberliegen und die Mehrschichtkörper (40, 50) so einen zwischen den Oberflächen (44, 54) angeordneten Prozessraum (21') ausbilden, in dem im Wesentlichen die Prozessierung erfolgt.

16. Anlage (10) zum Prozessieren, insbesondere zum Selenisieren, von mindestens zwei Gegenständen, insbesondere von mindestens zwei Mehrschichtkörpern (40, 50), mit jeweils mindestens einer zu prozessierenden Oberfläche (44, 54), umfassend
- mindestens eine Prozesskammer (11) mit einem Kammerraum (12),
- eine Vorrichtung (30a bis 30g) zum Positionieren der mindestens zwei Gegenstände nach einem der Ansprüche 1 bis 13.

17. Verfahren zum Positionieren von mindestens zwei Gegenständen, insbesondere von mindestens zwei Mehrschichtkörpern (40, 50) mit jeweils mindestens einer zu prozessierenden Oberfläche (44, 54),
mittels einer Vorrichtung (30a bis 30g) zum Positionieren der mindestens zwei Gegenstände, insbesondere Mehrschichtkörper, die zur Aufnahme der mindestens zwei Gegenstände, insbesondere der Mehrschichtkörper, ausgebildet ist,
wobei das Verfahren folgende Schritte umfasst:
- Anordnen der Vorrichtung (30a bis 30g) an einer dafür vorgesehenen Stelle,
- Anordnen der zwei Gegenstände, insbesondere der zwei Mehrschichtkörper (40, 50), an der Vorrichtung (30a bis 30g) derart, dass sich die jeweils zu prozessierenden Oberflächen (44, 54) gegenüberliegen und die Gegenstände, insbesondere Mehrschichtkörper (40, 50), so einen zwischen den Oberflächen (44, 54) angeordneten Prozessraum (21') ausbilden, in dem im Wesentlichen die Prozessierung erfolgt,
so dass die mindestens zwei Gegenstände als eine Mehrschichtkörperanordnung (28a, 28b, 28c, 28d, 28e) in einer Prozessieranlage (10) prozessierbar, insbesondere selenisierbar sind.

18. Verfahren zum Positionieren von mindestens zwei Gegenständen, insbesondere von mindestens zwei Mehrschichtkörpern (40, 50) mit jeweils mindestens einer zu prozessierenden Oberfläche (44, 54),
wobei das Verfahren folgenden Schritt umfasst:
Anordnen der zwei Gegenstände, insbesondere der zwei Mehrschichtkörper (40, 50) derart,
dass sich die jeweils zu prozessierenden Oberflächen (44, 54) gegenüberliegen und die Gegenstände, insbesondere Mehrschichtkörper (40, 50), so einen zwischen den Oberflächen (44, 54) angeordneten Prozessraum (21') ausbilden,
in dem im Wesentlichen die Prozessierung erfolgt,
so dass die mindestens zwei Gegenstände als eine
Mehrschichtkörperanordnung (28a, 28b, 28c, 28d, 28e) in einer Prozessieranlage (10) prozessierbar, insbesondere selenisierbar sind.
